# EUROPEAN PATENT SPECIFICATION

(11) **EP 1 509 924 B1**
(45) Date of publication and mention of the grant of the patent: **12.03.2008**
(21) Application number: 03733285.5
(22) Date of filing: 04.06.2003
(51) Int. Cl.: G11C 29/00, G11C 7/22

(54) **SEMICONDUCTOR MEMORY DEVICE WITH TEST MODE TO MONITOR INTERNAL TIMING CONTROL SIGNALS AT I/O TERMINALS**
HALBLEITERSPEICHERSCHALTUNG MIT TESTMODUS ZUR BEOBACHTUNG VON INTERNEN ZEITSTEUERSIGNALEN AN EIN-/AUSGABEANSCHLÜSSEN
DISPOSITIF DE MEMOIRE A SEMICONDUCTEURS A MODE ESSAI POUR LE CONTROLE DES SIGNAUX DE COMMANDE TEMPORISATION INTERNES A 1/0

(30) Priority: 06.06.2002 JP 2002165286
(43) Date of publication of application: 02.03.2005
(73) Proprietor: KABUSHIKI KAISHA TOSHIBA, Tokyo 105-8001 (JP); Infineon Technologies AG, 81669 München (DE)
(72) Inventor: MIYAKAWA, Tadashi Toshiba Corporation, Tokyo 105-8001 (JP); TAKASHIMA, Daisaburo Toshiba Corporation, Tokyo 105-8001 (JP); ROEHR, Thomas, 85609 Aschheim (DE)
(74) Representative: HOFFMANN EITLE
(86) International application number: PCT/JP2003/007068
(87) International publication number: WO 2003/105157

(56) References cited:
- US-A- 5 151 881
- US-B1- 6 252 820
- US-B1- 6 392 948

## Description

The present invention relates to a semiconductor memory device. More specifically, the invention relates to a semiconductor memory chip capable of easily analyzing an internal operation thereof.

Conventionally, a probing method and a method using an electron beam have been used to analyze an internal operation of a semiconductor chip.

The probing method is to directly read timing of internal signals and variations in voltage by applying a probe to a node in a semiconductor chip. In this method, the probe needs to be directly applied to the node. Therefore, a sample chip for evaluating an internal operation of the chip has to be formed through a process such as a removal of an oxide film from above a wiring layer. This method requires a lot of time to evaluate the internal operation. Since, moreover, the probe is brought into direct contact with the node in the chip, the sample chip is easily destroyed at the time of the evaluation. In this case, a sample chip is often formed from the beginning; thus, it is difficult to evaluate the internal operation of the chip with efficiency.

The method using an electron beam is to evaluate timing of internal signals and variations in voltage by emitting an electron beam to a node in a semiconductor chip and two-dimensionally reading variations in the potential of the node. This method necessitates a very expensive, large-sized apparatus and a sample chip for the evaluations. This method therefore requires a lot of time to make the evaluations and increase the costs therefor. As in the above probing method, it is difficult to make the evaluations with efficiency.

Since the above conventional methods require a sample chip and a lot of time, efficient evaluations cannot be performed for a target chip. The methods also require a special-purpose apparatus and thus efficient evaluations are difficult to make in terms of costs. Moreover, the conventional methods are not suitable for acquiring a large amount of data in order to make evaluations in view of variations in lots and wafers.

As a method of resolving the above problems, a semiconductor memory device that is easy to verify and evaluate its characteristics has recently been proposed (disclosed in, for example, Jpn. Pat. Appln. KOKAI Publication No. 2001-52498 corresponding to U. S. Patent No. 6,252, 820). According to the proposed semiconductor memory device, an SRAM (static random access memory) for reading/writing data to/from a memory cell array by generating an internal control signal from a control signal generation circuit in response to a clock signal includes a monitor control signal input terminal, an output buffer for monitoring, and a monitor output terminal. Such a configuration allows the timing and pulse widths of internal control signals that are generated in response to clock signals to be monitored.

In other words, the above mentioned prior art documents describe a semiconductor memory device capable of monitoring and adjusting the timing and pulse width of internal control signals. The memory device comprises a memory cell matrix and a plurality of I/O lines for writing data to and reading data from the cell matrix. A test mode setting circuit is provided for setting a test mode to monitor a plurality of timing signals which control the I/O operation timing of the cell data. Further, a switch circuit is provided for simultaneously outputting a timing signal from an output terminal in the test mode.

In the semiconductor memory device, however, some of the internal control signals are output from the special-purpose monitor output terminal. The monitor output terminal is covered with an envelope when the SRAM is packaged. Thus, the characteristics of the device cannot be verified or evaluated after the packaging of the SRAM.

As described above, the prior art semiconductor memory device can monitor the timing and pulse widths of internal control signals. However, the device has a problem that its characteristics cannot be verified or evaluated after packaging.

A semiconductor memory device according to the present invention comprises the features set out in claim 1. Advantageous embodiments are described in the dependent claims.

### Brief Description of Drawings

FIG. 1 is a block diagram showing a first example of a configuration of a semiconductor memory device (semiconductor memory chip) instrumental in describing the present invention.
FIG. 2 is a circuit diagram showing an example of arrangement of an internal control signal generation circuit in the semiconductor memory chip shown in FIG. 1.
FIG. 3 is a circuit diagram showing an example of arrangement of an operation control circuit in the semiconductor memory chip shown in FIG. 1.
FIG. 4 is a circuit diagram showing an example of arrangement of decoder circuits in the semiconductor memory chip shown in FIG. 1.
FIG. 5 is a circuit diagram showing an example of arrangement of column select circuits in the semiconductor memory chip shown in FIG. 1.
FIG. 6 is a circuit diagram showing an example of arrangement of data input/output buffer circuits in the semiconductor memory chip shown in FIG. 1.
FIG. 7 is a circuit diagram showing an example of arrangement of switch circuits in the semiconductor memory chip shown in FIG. 1.
FIG. 8 is a circuit diagram showing an example of arrangement of a test control circuit in the semiconductor memory chip shown in FIG. 1.
FIGS. 9A and 9B are circuit diagrams each showing another example of arrangement of the test control circuit.
FIGS. 10A and 10B are circuit diagrams each showing still another example of arrangement of the test control circuit.
FIG. 11 is a block diagram showing a second example of a configuration of a semiconductor memory device (semiconductor memory chip) instrumental in describing the present invention.
FIG. 12 is a circuit diagram showing an example of arrangement of a test control circuit in the semiconductor memory chip shown in FIG. 11.
FIG. 13 is a circuit diagram showing an example of arrangement of an internal control signal generation circuit in the semiconductor memory chip shown in FIG. 11.
FIG. 14 is a circuit diagram showing an example of arrangement of data input/output buffer circuits in the semiconductor memory chip shown in FIG. 11.
FIG. 15 is a circuit diagram showing an example of arrangement of switch circuits in the semiconductor memory chip shown in FIG. 11.
FIG. 16 is a signal waveform chart explaining a read operating monitor test mode in the semiconductor memory chip shown in FIG. 11.
FIG. 17 is a block diagram showing a third example of a configuration of a semiconductor memory device (semiconductor memory chip) instrumental in describing the present invention.
FIG. 18 is a circuit diagram showing an example of arrangement of a quasi-row decoder circuit in the semiconductor memory chip shown in FIG. 17.
FIG. 19 is a circuit diagram showing an example of arrangement of a quasi-column select circuit in the semiconductor memory chip shown in FIG. 17.
FIG. 20 is a signal waveform chart explaining a read operating monitor test mode in the semiconductor memory chip shown in FIG. 17.
FIG. 21 is a block diagram showing a fourth example of a configuration of a semiconductor memory device (semiconductor memory chip) instrumental in describing the present invention.
FIG. 22 is a circuit diagram showing an example of arrangement of an internal control signal generation circuit in the semiconductor memory chip shown in FIG. 21.
FIG. 23 is a circuit diagram showing an example of arrangement of a test control circuit in the semiconductor memory chip shown in FIG. 21.
FIG. 24 is a block diagram showing a fifth example of a configuration of a semiconductor memory device (semiconductor memory chip) instrumental in describing the present invention.
FIG. 25 is a block diagram showing an example of a configuration of a semiconductor memory device (semiconductor memory chip) according to an embodiment of the present invention.
FIG. 26 is a circuit diagram showing an example of arrangement of a test control circuit in the semiconductor memory chip shown in FIG. 25.
FIG. 27 is a circuit diagram showing an example of arrangement of switch circuits in the semiconductor memory chip shown in FIG. 25.
FIG. 28 is a block diagram showing an example of a configuration of a semiconductor memory device (semiconductor memory chip) according to another embodiment of the present invention.
FIG. 29 is a circuit diagram showing an example of arrangement of a test control circuit in the semiconductor memory chip shown in FIG. 28.

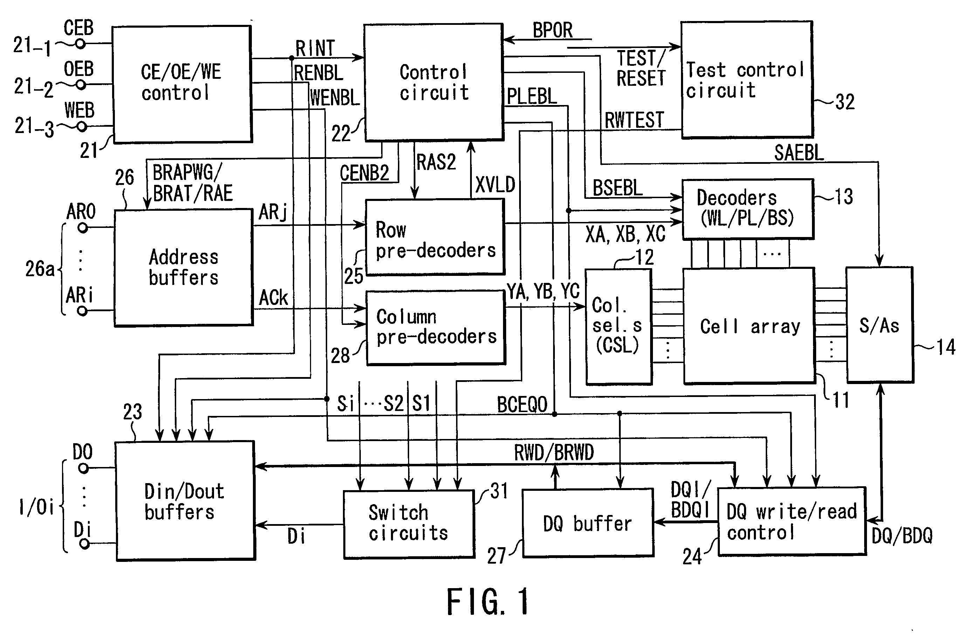

FIG. 1 shows a first example of a configuration of a semiconductor memory device (semiconductor memory chip) instrumental in describing the present invention. In the first example, switch circuits and a test control circuit serving as a test mode setting circuit are added to the existing semiconductor memory chip to allow a plurality of timing control signals, which controls the operation timing in the chip, to be monitored at the same time.

In FIG. 1, a memory cell array 11 includes a plurality of memory cells (not shown) that are arranged in matrix to read/write cell data. The memory cell array 11 also includes a plurality of word lines and a plurality of bit lines that intersect each other at right angles. The memory cells are located at their respective intersections of the word and bit lines.

Column select circuits 12 and decoder circuits 13 are arranged adjacent to the memory cell array 11.

Sense amplifier circuits 14 are arranged close to the memory cell array 11.

External input terminals 21_1, 21_2 and 21_3 are connected to an internal control signal generation circuit 21. An operation control circuit 22, data input/output buffer circuits 23, and a data write/read control circuit 24 are also connected to the circuit 21.

The internal control signal generation circuit 21 is supplied with external control signals from the external input terminals 21_₁, 21_₂ and 21_₃. Of the external control signals, a chip enable signal CEB is supplied from the terminal 21_₁, an output enable signal OEB is supplied from the terminal 21_₁, and a write enable signal WEB is supplied from the terminal 21_₃. The circuit 21 generates an internal control signal RINT based on the external control signals and sends it to both the operation control circuit 22 and the data input/output buffer circuits 23. The circuit 21 also generates an internal control signal (read operation control signal) RENBL and sends it to the data input/output buffer circuits 23. The circuit 21 also generates an internal control signal (write operation control signal) WENBL and sends it to both the data input/output buffer circuits 23 and the data write/read control circuit 24.

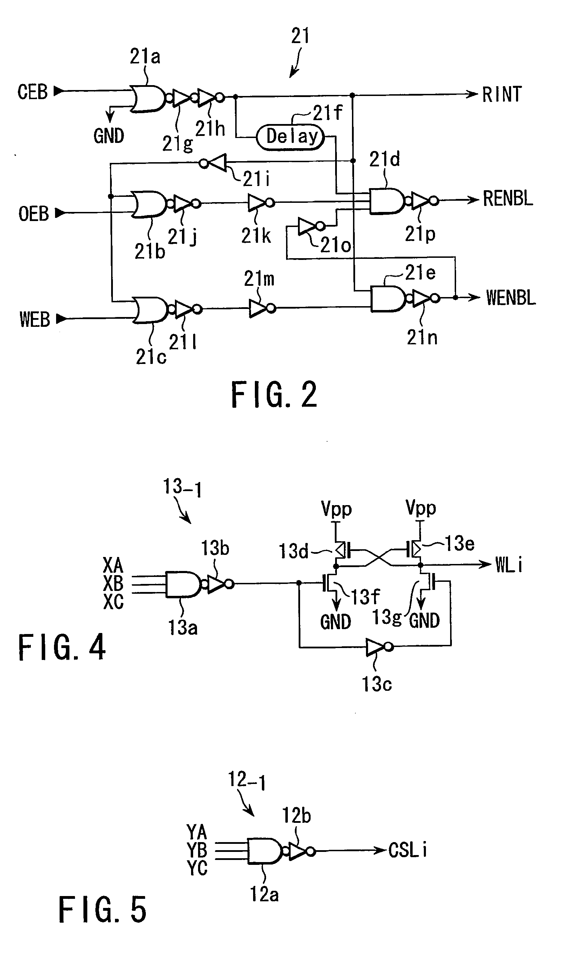

The internal control signal generation circuit 21 includes three NOR circuits 21a, 21b and 21c, two NAND circuits 21d and 21e, one delay circuit 21f, and ten inverter (NOT) circuits 21g, 21h,..., and 21p, as illustrated in FIG. 2. The chip enable signal CEB is supplied to one input terminal of the NOR circuit 21a. The other input terminal of the NOR circuit 21a is grounded (GND). An output of the NOR circuit 21a is produced as a signal RINT through the inverter circuits 21g and 21h. An output (signal RINT) of the inverter circuit 21h is supplied to a first input terminal of the NAND circuit 21d via the delay circuit 21f. The output (signal RINT) of the inverter circuit 21h is also supplied to one input terminal of the NAND circuit 21e and supplied to one input terminal of each of the NOR circuits 21b and 21c via the inverter circuit 21i. The signal OEB is supplied to the other input terminal of the NOR circuit 21b. An output of the NOR circuit 21b is supplied to a second input terminal of the NAND circuit 21d through the inverter circuits 21j and 21k. The signal WEB is supplied to the other input terminal of the NOR circuit 21c. An output of the NOR circuit 21c is supplied to the other input terminal of the NAND circuit 21e via the inverter circuits 211 and 21m. An output of the NAND circuit 21e is produced as a signal WENBL through the inverter circuit 21n and supplied to a third input terminal of the NAND circuit 21d through the inverter circuit 21o. An output of the NAND circuit 21d is produced as a signal RENBL through the inverter circuit 21p.

In a standby state, the level of signal CEB input to the internal control signal generation circuit 21 is high (H). In contrast, the levels of signals RINT, RENBL and WENBL output from the circuit 21 are all low (L), irrespective of the levels of input signals OEB and WEB. In an active state, e.g., a normal cell data read mode, the levels of signals CEB and OEB input to the circuit 21 is low and the level of signal WEB input thereto is high. In contrast, the levels of signals RINT and RENBL output from the circuit 21 are high and the level of signal WENBL output therefrom is low. In a normal cell data write mode, the levels of signals CEB and WEB input to the circuit 21 is low and the level of signal OEB input thereto is high. In contrast, the levels of signals RINT and WFNBL output from the circuit 21 are high and the level of signal RENBL output therefrom is low.

According to the first example, if the signal CEB input to the circuit 21 is set at a low level and the signals OEB and WEB input thereto are set at a high level in a test mode other than the normal read and write modes, a read monitor test mode can be executed. In other words, the device is set in the test mode and then goes into an active state (the level of signal CEB is low) and a disable state (the levels of signals OEB and WEB are high) in which cell data is inhibited from being read or written. It is thus possible to start a read monitor test mode in which a plurality of timing control signals can simultaneously be monitored in an internal circuit in the normal read state.

The decoder circuits 13, sense amplifier circuits 14, internal control signal generation circuit 21, data write/read control circuit 24, row predecoder circuits 25, address buffer circuits 26, data buffer circuits 27, and column predecoder circuits 28 are connected to the operation control circuit 22.

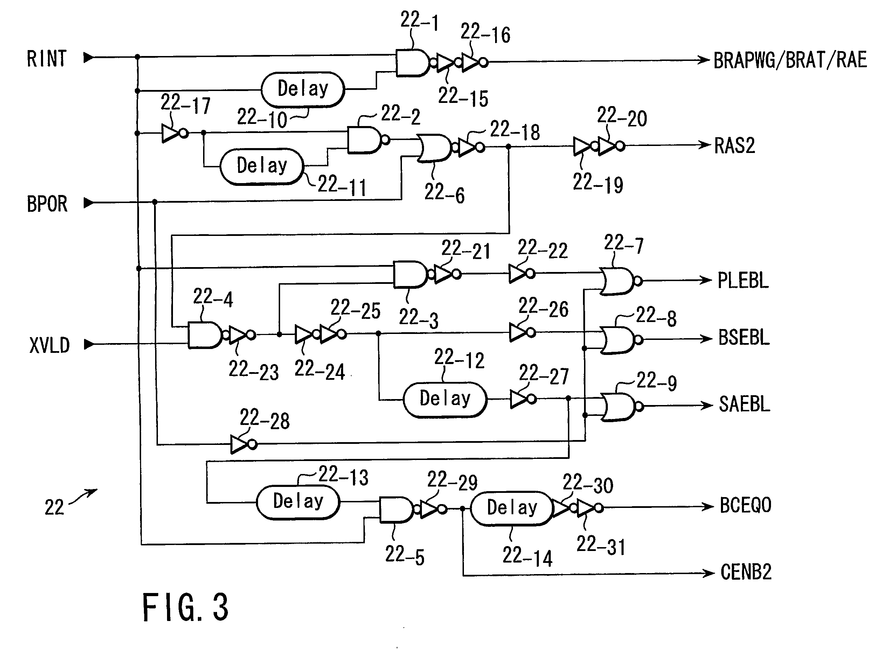

As shown in FIG. 3, the operation control circuit 22 includes five NAND circuits 22_₁, 22_₂, 22_₃, 22_₄ and 22_₅, four NOR circuits 22_₆, 22_₇, 22_₈, and 22_₉, five delay circuits 22_₁₀, 22_₁₁, 22_₁₂, 22_₁₃ and 22_₁₄, and seventeen inverter circuits 22_₁₅, 22_₁₆,..., and 22_₃₁.

The operation control circuit 22 is supplied with signals RINT, XVLD and BPOR. For example, the signal RINT is supplied from the internal control signal generation circuit 21 and the signal XVLD is supplied from the row predecoder circuits 25. In response to these signals, the operation control circuit 22 generates signals BRAPWG, BRAT and RAE and transmits them to the address buffer circuits 26. The circuit 22 generates a signal RAS2 and supplies it to the row predecoder circuits 25. The circuit 22 generates a plate line enable signal PLEBL and sends it to both the decoder circuits 13 and the data write/read control circuit 24. The circuit 22 generates a block select line enable signal BSEBL and transmits it to the decoder circuits 13. The circuit 22 generates a sense amplification enable signal SAEBL and outputs it to the sense amplifier circuits 14. The circuit 22 generates a signal BCEQO and supplies it to the data input/output buffer circuits 23, data write/read control circuit 24, and data buffer circuit 27. The circuit 22 generates a signal CENB2 and outputs it to the column predecoder circuits 28.

A plurality of address input terminals 26a (a = 0 to i) are connected to the address buffer circuits 26. The operation control circuit 22, row predecoder circuits 25, and column predecoder circuits 28 are connected to the address buffer circuits 26.

The address buffer circuits 26 are supplied with external address signals ARi (i = 0 to i) from the address input terminals 26a and signals BRAPWG, BRAT and RAE from the operation control circuit 22. In response to these signals, the address buffer circuits 26 generate a signal ARj and supply it to the row predecoder circuits 25. The circuits 26 also generate a column address signal ACk and supply it to the column predecoder circuits 28.

The decoder circuits 13, operation control circuit 22, and address buffer circuits 26 are connected to the row predecoder circuits 25.

The signal RAS2 is supplied to the row predecoder circuits 25 from the operation control circuit 22 and the signal ARj is supplied to the circuits 25 from the address buffer circuits 26. In response to these signals, the row predecoder circuits 25 generate a signal XVLD and supply it to the operation control circuit 22. The circuits 25 also generate row address signals XA, XB and XC and send them to the decoder circuits 13.

The memory cell array 11, operation control circuit 22, and row predecoder circuits 25 are connected to the decoder circuits 13.

The signals PLEBL and BSEBL are supplied to the decoder circuits 13 from the operation control circuit 22 and the signals XA, XB and XC are supplied to the circuits 13 from the row predecoder circuits 25. In response to these signals, the circuits 13 generate an operating voltage according to an operating mode.

The decoder circuits 13 include a plurality of row decoders 13_₁. FIG. 4 shows an example of one of the row decoders 13_₁. The number of row decoders 13_₁ corresponds to that of word lines WLi (e.g., i = 0 to 1023). Each of the row decoders 13_₁ includes one NAND circuit 13a, two inverter circuits 13b and 13c, two p-channel MOS transistors 13d and 13e, and two n-channel MOS transistors 13f and 13g. The row decoders 13_₁ generate word line voltages (operating voltages) in response to the signals XA, XB and XC to selectively drive the word lines WLi in the memory cell array 11.

The decoder circuits 13 also include a circuit (not shown) for selectively driving the plate lines (PL) in the memory cell array 11 in response to the signal PLEBL and a circuit (not shown) for selectively driving the block select lines (BS) in the memory cell array 11 in response to the signal BSEBL.

The column select circuits 12, operation control circuit 22 and address buffer circuits 26 are connected to the column predecoder circuits 28.

The signal CENB2 is supplied to the column predecoder circuits 28 from the operation control circuit 22 and the signal ACk is supplied to the circuits 28 from the address buffer circuits 26. In response to these signals, the circuits 28 generate column address signals YA, YB and YC and supply them to the column select circuits 12.

The memory cell array 11 and column predecoder circuits 28 are connected to the column select circuits 12.

The column select circuits 12 generate column select signals in response to the signals YA, YB and YC from the column predecoder circuits 28 to selectively drive the column select lines CSLi in the memory cell array 11.

The column select circuits 12 include a plurality of column selectors 12_₁ as illustrated in FIG. 5. The number of column selectors 12_₁ corresponds to that of column select lines CSLi (e.g., i = 0 to 511). Each of the column selectors 12_₁ includes one NAND circuit 12a and one inverter circuit 12b.

The memory cell array 11, operation control circuit 22, and data write/read control circuit 24 are connected to the sense amplifier circuits 14.

The signal SAEBL is supplied to the sense amplifier circuits 14 from the operation control circuit 22. Thus, the circuits 14 amplify the potential of each of the bit lines (BL) in the memory cell array 11. The sense amplifier circuits 14 sense cell data supplied to the bit lines BL from the memory cell array 11 in, for example, the normal read mode. Then, the circuits 14 convert the cell data into data DQ and BDQ and send them to the data write/read control circuit 24. In the normal write mode, the sense amplifier circuits 14 receive the data DQ and BDQ from the circuit 24 and output them to the memory cell array 11.

The sense amplifier circuits 14, internal control signal generation circuit 21, operation control circuit 22, data input/output buffer circuits 23, and data buffer circuit 27 are connected to the data write/read control circuit 24.

The signal WENBL is supplied to the data write/read control circuit 24 from the internal control signal generation circuit 21. The signals PLEBL and BCEQO are supplied to the circuit 24 from the operation control circuit 22. Data DQ and BDQ are transferred between the circuit 24 and the sense amplifier circuit 14. Data RWD and BRWD are transferred between the circuit 24 and the data input/output buffer circuits 23. Further, the circuit 24 supplies data DQI and BDQI to the data buffer circuit 27.

The data write/read control circuit 24 receives data RWD and BRWD from the data input/output buffer circuits 23 in, for example, the normal write mode. Then, the circuit 24 converts the data RWD and BRWD into data DQ and BDQ and supplies them to the sense amplifier circuits 14. In, for example, the normal read mode, the circuit 24 receives data DQ and BDQ from the sense amplifier circuits 14. The circuit 24 converts data DQ and BDQ into data DQI and BDQI and stores them in the data buffer circuit 27.

The operation control circuit 22, data input/ output buffer circuits 23, and data write/read control circuit 24 are connected to the data buffer circuit 27.

The signal BCEQO is supplied to the data buffer circuit 27 from the operation control circuit 22. The data buffer circuit 27 receives data DQI and BDQI from the data write/read control circuit 24 in, for example, the normal read mode. Then, the circuit 27 converts the data DQI and BDQI into data RWD and BRWD and supplies them to the data input/output buffer circuits 23.

A plurality of data input/output terminals I/Oi (e.g., i = 0 to 15) are connected to the data input/output buffer circuits 23. The internal control signal generation circuit 21, operation control circuit 22, data write/read control circuit 24, and data buffer circuit 27 are connected to the data input/output buffer circuits 23.

The data input/output buffer circuits 23 are supplied with data Di (i = 0 to 15) as cell data from the data input/output terminals I/Oi. The circuits 23 are also supplied with signals RINT, RENBL and WENBL from the internal control-signal generation circuit 21. Further, the circuits 23 are supplied with signal BCEQO from the operation control circuit 22. The circuits 23 convert the data Di into data RWD and BRWD and send them to the data write/read control circuit 24 (in the normal write mode). The circuits 23 also convert the data RWD and BRWD into data Di and output it from the data input/output terminals I/Oi (in the normal read mode).

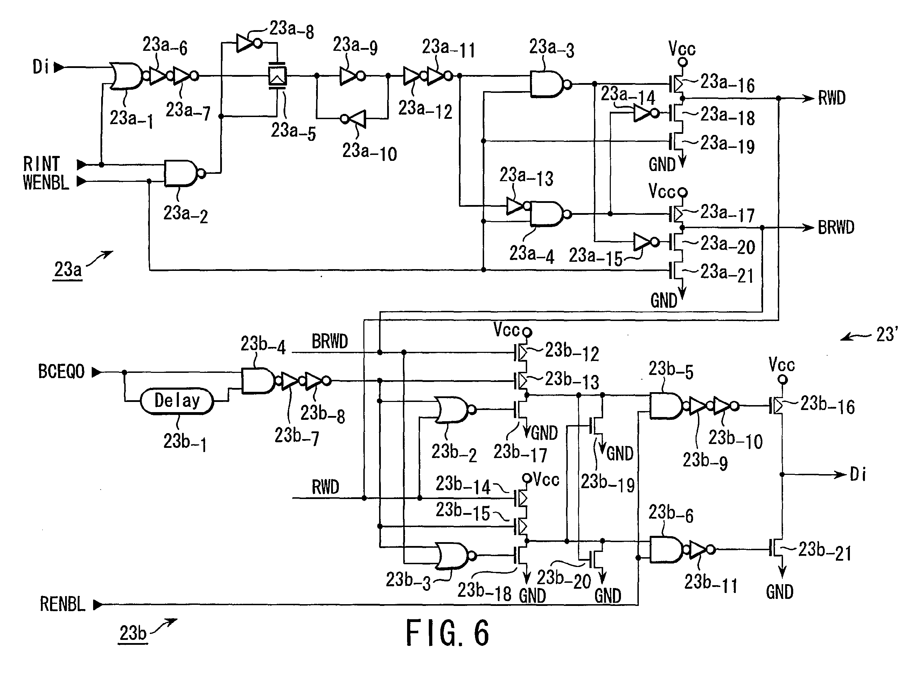

The data input/output buffer circuits 23 include a plurality of data input/output buffer circuits 23'. FIG. 6 shows an example of one of the data input/output buffer circuits 23'. Each of the circuits 23'includes a first circuit 23a and a second circuit 23b.

The first circuit 23a serves to acquire data RWD and BRWD from data Di in response to signals RINT and WENBL and includes one NOR circuit 23a_₁, three NAND circuits 23a_₂, 23a_₃ and 23a_₄, one transfer gate 23a_5, ten inverter circuits 23a_₆, 23_₇, ..., and 23a_₁₅, two p-channel MOS transistors 23a_₁₆ and 23a_₁₇, and four n-channel MOS transistors 23a_₁₈, 23a_₁₉, 23a_₂₀, and 23a_₂₁.

The second circuit 23b serves to acquire data Di from data RWD and BRWD in response to signals BCEQO and RENBL and includes one delay circuit 23b_₁, two NOR circuits 23b_₂ and 23b_₃, three NAND circuits 23b_₄, 23b_₅ and 23b_₆, five inverter circuits 23b_₇, 23b_₈, ..., and 23b_₁₁, five p-channel MOS transistors 23b_₁₂, 23b_₁₃, ... and 23b_₁₆, and five n-channel MOS transistors 23b_₁₇, 23b_₁₈, ... and 23b_₂₁.

Actually, these data input/output buffer circuits 23'are provided for their respective data input/output terminals I/Oi.

Switch circuits 31 are connected to the data input/output buffer circuits 23. In other words, the circuits 23 receive data Di from the switch circuits 31 and then output it from the data input/output terminals I/Oi (e.g., in the read monitor test mode).

The internal control signal generation circuit 21, operation control circuit 22, data input/output buffer circuits 23, data write/read control circuit 24, row predecoder circuits 25, data buffer circuit 27, and test control circuit (test mode setting circuit) 32 are connected to the switch circuits 31.

The switch circuits 31 receive an output test signal RWTEST from the test control circuit 32 in, for example, the read monitor test mode. Thus, the circuits 31 convert a plurality of timing control signals, which are supplied as input signals Si (i = 1 to i), into data Di and supply it to the data input/output buffer circuits 23. The timing control signals are output from the data input/output terminals I/Oi as data Di.

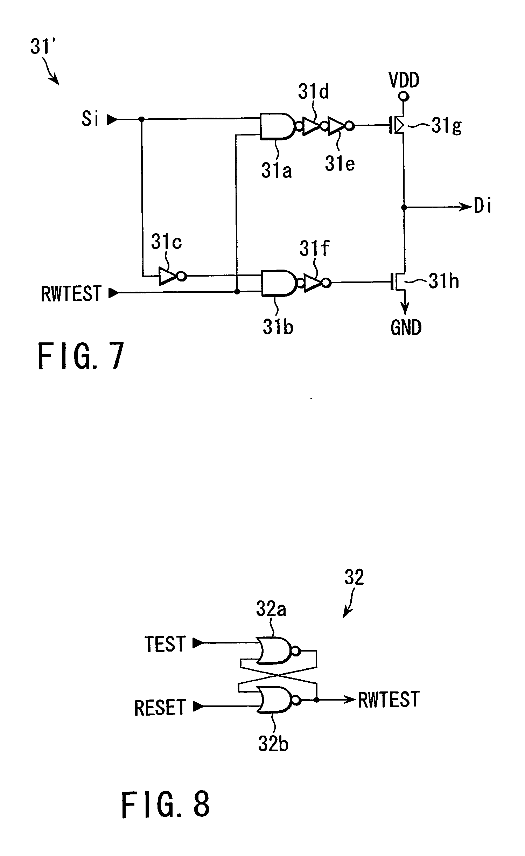

The switch circuits 31 include a plurality of switch circuits 31'. FIG. 7 shows an example of one of the switch circuits 31'. The switch circuits 31' are provided for their respective data input/output terminals I/Oi. Each of the switch circuits 31' includes two NAND circuits 31a and 31b, four inverter circuits 31c, 31d, 31e and 31f, one p-channel MOS transistor 31g, and one n-channel MOS transistor 31h (first tristate circuit).

An input signal Si is supplied to one input terminal of the NAND circuit 31a and also supplied to one input terminal of the NAND circuit 31b via the inverter circuit 31c. A signal RWTEST is supplied to the other input terminals of the NAND circuits 31a and 31b. The output terminal of the NAND circuit 31a is connected to the gate of the p-channel MOS transistor 31g through the inverter circuits 31d and 31e. The source of the transistor 31g is connected to an external power supply VDD. The output terminal of the NAND circuit 31b is connected to the gate of the n-channel MOS transistor 31h through the inverter circuit 31f. The source of the transistor 31h is grounded (GND). The drains of both the transistors 31g and 31h are connected to each other. Data Di is output from the common drain of the transistors 31g and 31h.

The p-channel MOS transistor 31g and n-channel MOS transistor 31h both turn off in the normal read mode and normal write mode (the level of signal RWTEST is low in both the modes). Thus, the data Di output from the switch circuits31'is brought into a high- impedance state (Di = Hi-z). The data Di depends upon the input signal Si in the read monitor test mode (the level of signal RWTEST is high). If the level of the input signal Si is high (H), that of data Di becomes high. If the level of the input signal Si is low (L), that of data Di becomes low.

According to the first example, signals RINT, RAS2, XVLD, BSEBL, PLEBL, SAEBL, CENB2, and BCEQO and data DQ(0), BDQ(0), RWD(0), and BRWD(0) can simultaneously be monitored as timing control signals in, for example, the normal read mode. Of the input signals Si (i = 1 to 15) of the switch circuits 31', the input signals S(1), S(2), S(3), S(4), S(5), S(6), S(7), S(8), S(9), S(10), S(11) and S(12) correspond to RINT, RAS2, XVLD, BSEBL, PLEBL, SAEBL, CENB2, BCEQO, DQ(0), BDQ(0), RWD(0) and BRWD(0), respectively.

Aside from the timing control signals, the cell data actually read out of the memory cell array 11 can be output from the data input/output terminals I/Oi.

A test entry circuit (not shown), the switch circuits 31, etc. are connected to the test control circuit 32.

FIG. 8 shows an example of arrangement of the test control circuit 32 described above. The circuit 32 includes two NOR circuits 32a and 32b.

A signal TEST is supplied to one input terminal of the NOR circuit 32a. A signal RESET is supplied to one input terminal of the NOR circuit 32b. An output of the NOR circuit 32a is supplied to the other input terminal of the NOR circuit 32b. An output of the NOR circuit 32b is supplied to the other input terminal of the NOR circuit 32a and produced as a signal RWTEST.

The test control circuit 32 receives a test signal (e.g., pulse signal) TEST from the test entry circuit in the read monitor test mode. In response to the signal, the circuit 32 generates a signal RWTEST (high level) and outputs it to the switch circuits 31. On the other hand, the test control circuit 32 stops the signal RWTEST from being output to the switch circuits 31 (the level of RWTEST is low) when the test mode is reset or when the circuit 32 receives a reset signal RESET from the test entry circuit. Consequently, the semiconductor memory device (chip) can operate in the normal operating mode.

The semiconductor memory chip so configured can be set in, for example, the read monitor test mode. In this test mode, a plurality of timing control signals in the internal operation in the normal read mode can be monitored at the same time. Upon receiving a test signal TEST, the test control circuit 32 performs a test entry operation and thus outputs a signal RWTEST (H) to the switch circuits 31. An output path of the timing control signals is therefore connected to the data input/output terminals I/Oi. In other words, the switch circuits 31 are connected to the data input/output terminals I/Oi through the data input/output buffer circuits 23. Then, the device is brought into an output disable state. For example, when the device is in an active state (the level of CEB is low), the output and input of cell data are inhibited (the levels of OEB and WEB are high). Thus, data Di corresponding to each of the input signals Si is supplied to the data input/output buffer circuits 23 from the switch circuits 31. Consequently, a plurality of timing control signals to be monitored can simultaneously be output from the data input/output terminals I/Oi.

In the first example, signals RINT, RAS2, XVLD, BSEBL, PLEBL, SAEBL, CENB2, and BCEQO and data DQ(0), BDQ(0), RWD(0), and BRWD(0) are output from the data input/output terminals I/O(1), I/O(2), 1/O(3), I/O(4), 1/O(5), I/O(6), I/O(7), 1/O(8), 1/O(9), I/O(10), I/O(11), and I/O(12), respectively, on a priority basis, without conflicting with the cell data. The timing control signals can thus be output from the data input/output terminals I/Oi, with the result that the internal operation of the semiconductor memory chip can efficiently be analyzed (the characteristics can be verified and evaluated) after the chip is packaged.

As described above, the plurality of timing control signals in the chip can be monitored at the same time even after the chip is packaged. In other words, the timing control signals in the chip can efficiently be output from the plurality of data input/output terminals used for input and output of cell data. It is thus possible to easily and accurately evaluate the timing of an internal operation, a delay in signal, etc. even after the chip is packaged. Consequently, the internal operation of the semiconductor memory chip, such as an operating margin, can be analyzed with high precision at low cost in a short time without forming any sample chip for evaluation or using any expensive apparatus exclusively for evaluation.

Since the plurality of timing control signals can be output at the same time, a relationship in timing between the timing control signals can be analyzed.
For example, the semiconductor memory chip of the present invention is favorable for acquiring a large amount of data in order to make evaluations in consideration of variations in lots and wafers.

According to the first example in particular, the switch circuits 31 and test control circuit 32 are simply added and the existing semiconductor memory chip need not be modified extensively. Consequently, the chip area and cost can be prevented from increasing, which is advantageous.

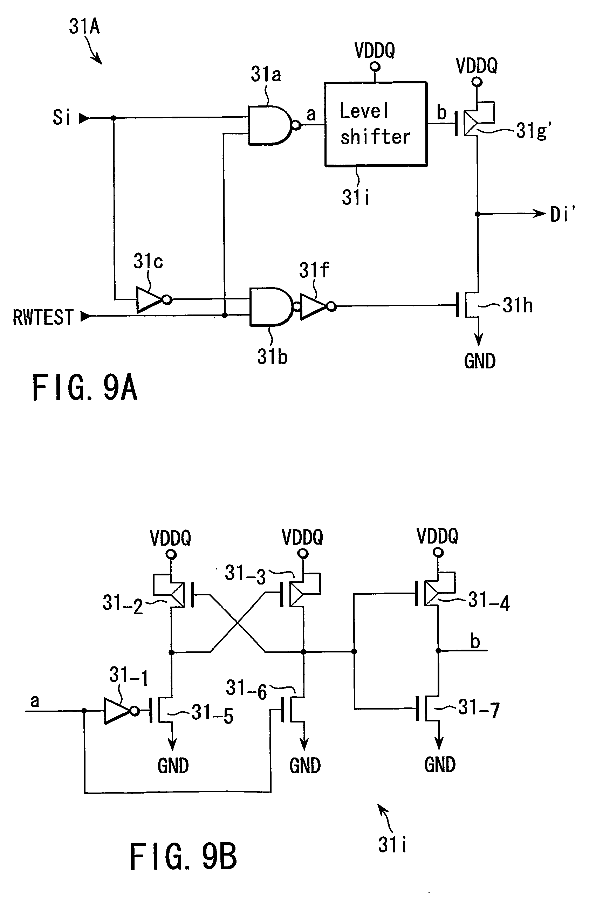

The switch circuits 31 are not limited to the foregoing arrangement. The switch circuits31'can be replaced with a switch circuit 31A shown in FIG. 9A. The switch circuit 31A employs a power supply voltage VDDQ exclusively for the output buffer circuits, which differs from the external power supply voltage VDD. In this case, a level shift circuit (level shifter) 31i is inserted as a voltage switch circuit between the output terminal (a) of the NAND circuit 31a and the gate (b) of a p-channel MOS transistor 31g'that forms a second tristate circuit by a series connection with the n-channel MOS transistor 31h. In other words, the switch circuit 31A includes the level shift circuit 31i in place of the inverter circuits 31d and31e of the switch circuit 31'shown in FIG. 7. The level shift circuit 31i is used to switch between the power supply voltage VDD and VDDQ and, as shown in FIG. 9B, includes one inverter circuit 31_₁, three p-channel MOS transistors 31_₂, 31_₂ and 31_₄, and three n-channel MOS transistors 31_₅, 31_₆ and 31_₇.

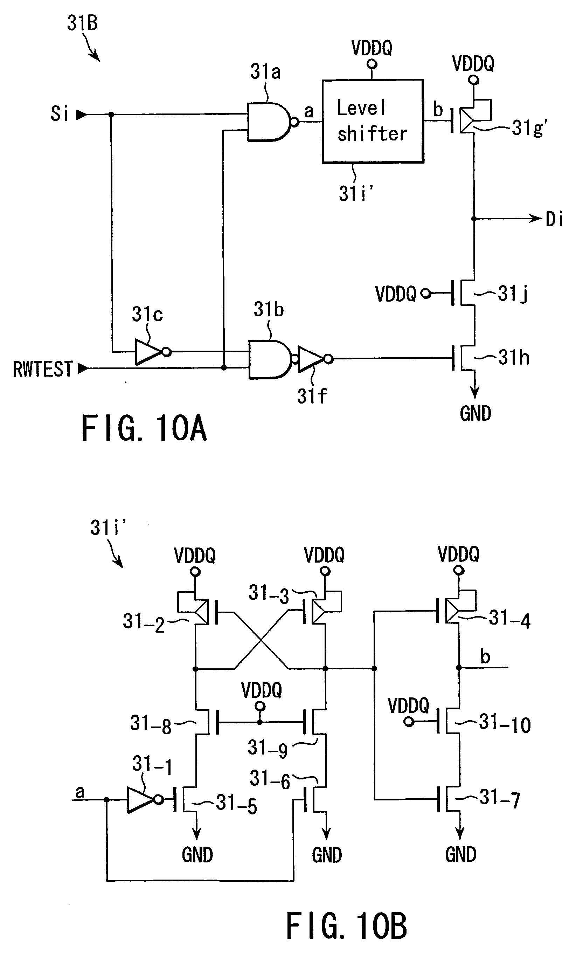

FIG. 10A shows an arrangement of a switch circuit 31B as another example of the switch circuits 31'. There is a semiconductor memory chip in which an internal circuit voltage Vin and a power supply voltage VDDQ exclusively for the output buffer circuits are selectively used in order to increase the speed of the internal operation and stabilize the operation. It is feared that transistors used in this type of semiconductor memory chip will decrease in breakdown voltage in accordance with the high performance such as low voltage and high speed. In the switch circuit 31B adopting such a transistor, an n-channel MOS transistor (protecting transistor) 31j is connected in series to an n-channel MOS transistor 31h, as shown in FIG. 10A. A positive potential such as the power supply voltage VDDQ is applied to the gate of the n-channel MOS transistor 31j. Similarly, n-channel MOS transistors (protecting transistors) 31_₈, 31_₉ and 31_₁₀ are connected in series to their respective n-channel MOS transistors 31_₅, 31_₆ and 31_₇ even in a level shift circuit 31i', as shown in FIG. 10B. The power supply voltage VDDQ (positive potential) is applied to the gates of the n-channel MOS transistors 31_₈, 31_₉ and 31_₁₀. Thus, the breakdown voltage of the n-channel MOS transistors 31h, 31_₅, 31_₆ and 31_₇ are improved, with the result that the breakdown voltage is improve in the inverter structure.

Needless to say, the same advantage as that in the case of the switch circuit31'can be obtained if one of the switch circuits 31A and 31B is used.

In the first embodiment, the timing control signals in the normal read mode can be monitored. Naturally, the timing control signals in the normal write mode can easily be monitored.

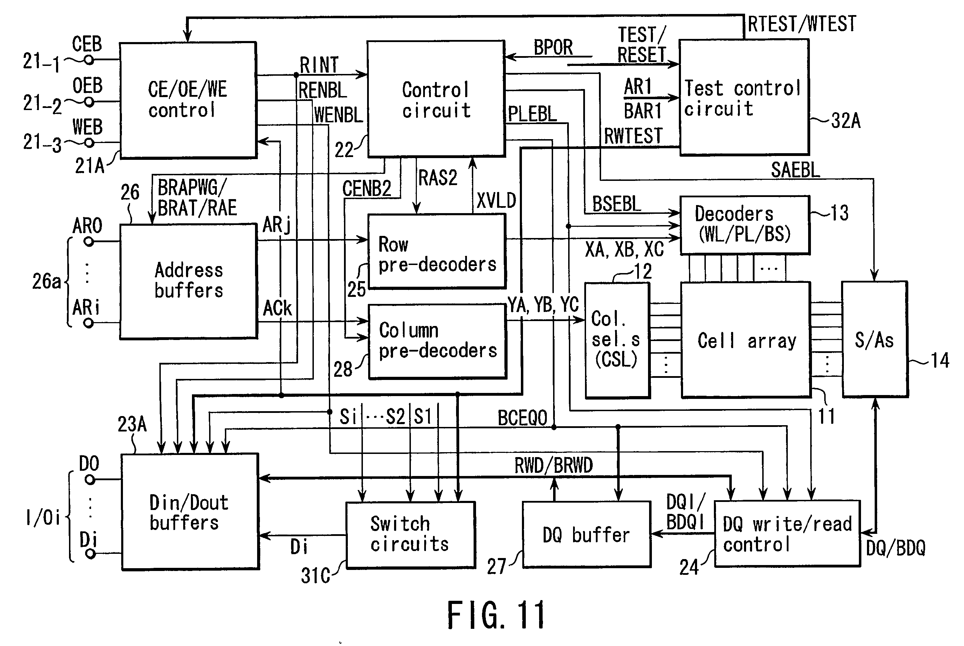

FIG. 11 shows a second example of a configuration of a semiconductor memory device (semiconductor memory chip) instrumental in describing the present invention. In the semiconductor memory device shown in FIG. 11, timing control signals in both the normal read mode and normal write mode can be monitored by bringing the device into a specific state when it is set in a test mode. The same components as those of the first embodiment are denoted by the same reference numerals and their detailed descriptions are omitted.

As illustrated in FIG. 11, a test control circuit (test mode setting circuit) 32A outputs an output test signal RWTEST to an internal control signal generation circuit 21A, data input/output buffer circuits 23A, and switch circuits 31C. The test control circuit 32A includes a state control circuit for supplying test signals RTEST and WTEST to the internal control signal generation circuit 21A.

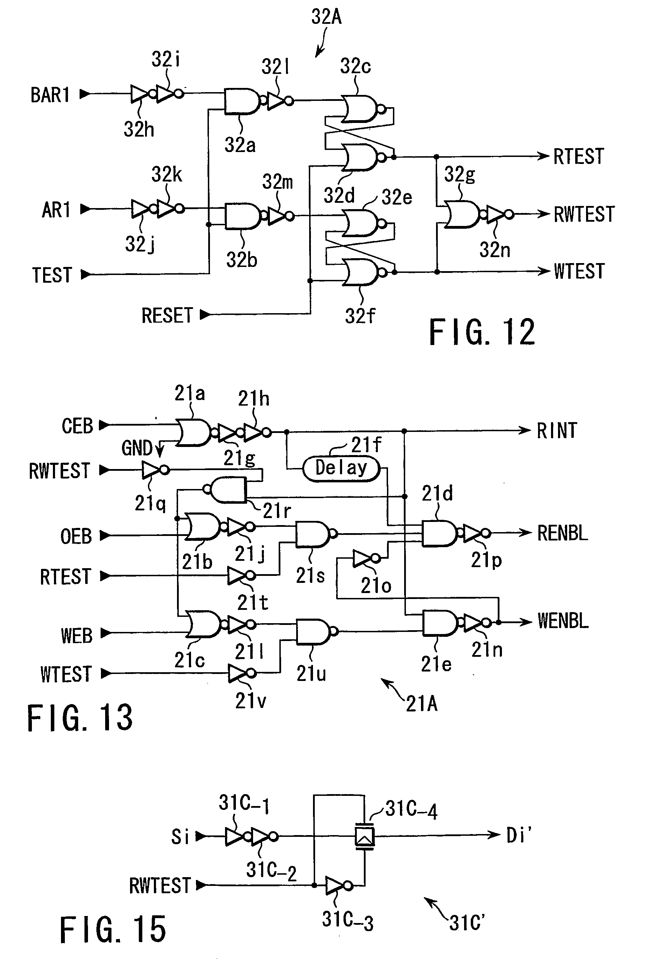

FIG. 12 shows an example of arrangement of the test control circuit 32A. The test control circuit 32A includes two NAND circuits 32a and 32b, five NOR circuits 32c, 32d, ..., and 32g, and seven inverter circuits 32h,32i, ..., and 32n.

More specifically, a signal BAR(1) is supplied to one input terminal of the NAND circuit 32a via the inverter circuits 32h and 32i. A signal TEST is supplied to the other input terminal of the NAND circuit 32a and one input terminal of the NAND circuit 32b. A signal AR(1) is supplied to the other input terminal of the NAND circuit 32b via the inverter circuits 32j and 32k. An output of the NAND circuit 32a is supplied to one input terminal of the NOR circuit 32c via the inverter circuit 321. An output of the NOR circuit 32c is supplied to one input terminal of the NOR circuit 32d. An output of the NOR circuit 32d is produced as a signal RTEST and supplied to the other input terminal of the NOR circuit 32c and one input terminal of the NOR circuit 32g. An output of the NAND circuit 32b is supplied to one input terminal of the NOR circuit 32e via the inverter circuit 32m. An output of the NOR circuit 32e is supplied to one input terminal of the NOR circuit 32f. A signal RESET is supplied to the other input terminals of the NOR circuits 32d and 32f. An output of the NOR circuit 32f is produced as a signal WTEST and supplied to the other input terminal of the NOR circuit 32e and the other input terminal of the NOR circuit 32g. An output of the NOR circuit 32g is produced as a signal RWTEST through the inverter circuit 32n.

When signal TEST is input, the level of signal RTEST becomes high (read monitor test mode) if the level of signal AR(1) is low and that of signal BAR(1) is high. When signal TEST is input, the level of signal WTEST becomes high (write monitor test mode) if the level of signal AR(1) is high and that of signal BAR(1) is low. The level of signal RWTEST becomes high if the level of one of signals RTEST and WTEST is high. When signal RESET is input, the levels of signals RTEST, WTEST and RWTEST all become low.

FIG. 13 shows an example of arrangement of the internal control signal generation circuit 21A. A signal CEB is supplied to one input terminal of a NOR circuit 21a. The other input terminal of the NOR circuit 21a is grounded (GND). An output of the NOR circuit 21a is produced as a signal RINT through inverter circuits 21g and 21h. The output signal RINT of the inverter circuit 21h is supplied to a first input terminal of a NAND circuit21d via a delay circuit 21f. The output signal RINT of the inverter circuit 21h is also supplied to one input terminal of each of NAND circuits21e and 21r. A signal RWTEST is supplied to the other input terminal of the NAND circuit 21r through an inverter circuit 21q. An output of the NAND circuit 21r is supplied to one input terminal of each of NOR circuits 21b and 21c. A signal OEB is supplied to the other input terminal of the NOR circuit 21b. An output of the NOR circuit 21b is supplied to one input terminal of a NAND circuit 21s through an inverter circuit 21j. A signal RTEST is supplied to the other input terminal of the NAND circuit 21s through an inverter circuit 21t. An output of the NAND circuit 21s is supplied to a second input terminal of the NAND circuit 21d. A signal WEB is supplied to the other input terminal of the NOR circuit 21c. An output of the NOR circuit21c is supplied to one input terminal of a NAND circuit21u through an inverter circuit 211. A signal WTEST is supplied to the other input terminal of the NAND circuit21u through an inverter circuit 21v. An output of the NAND circuit21u is supplied to the other input terminal of the NAND circuit 21e. An output of the NAND circuit21e is produced as a signal WENBL through an inverter circuit 21n and also supplied to a third input terminal of the NAND circuit 21d through an inverter circuit21o. An output of the NAND circuit 21d is produced as a signal RENBL through an inverter circuit21p.

When the level of signal RTEST is high, the internal control signal generation circuit 21A receives a low-level signal CEB and outputs a high-level signal RENBL. Thus, the memory chip starts to perform a normal read operation as an internal operation. On the other hand, when the level of signal WTEST is high, the circuit 21A receives a low-level signal CEB and outputs a high-level signal WENBL. Thus, the memory chip starts to perform a normal write operation as an internal operation. In the second example, the internal operation (read or write operation) is controlled only by setting of a test mode and timing of signal CEB, irrespective of signals OEB and WEB.

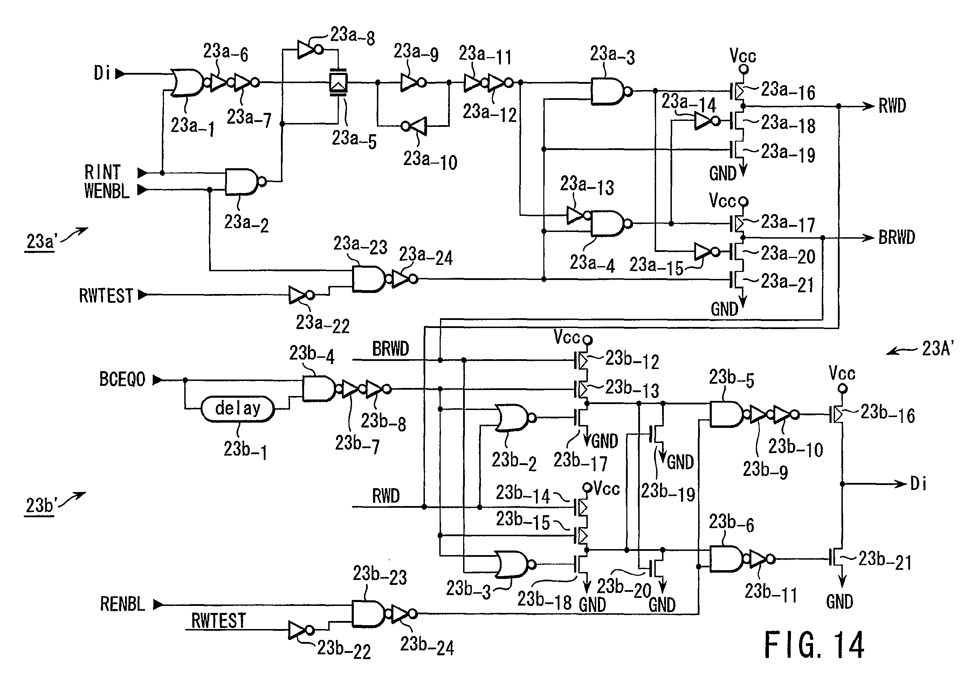

The data input/output buffer circuits 23A include a plurality of data input/output buffer circuits 23A'. FIG. 14 shows an example of arrangement of one of the data input/output buffer circuits 23A'. Each of the circuits 23A' corresponds to the data input/output buffer circuit 23' shown in FIG. 6. In each circuit 23A', a signal RWTEST is supplied to first and second circuits 23a' and 23b' via inverter circuits 23a_22 and 23b_22. An output of NAND circuit 23a_23, which receives an output of the inverter circuit 23a_22 and a signal WENBL, is supplied to the NAND circuits 23a_3 and 23a_4 and the gates of n-channel MOS transistors 23a_19 and 23a_21 through an inverter circuit 23a_24 (path switching circuit). Further, an output of NAND circuit 23b_23, which receives an output of the inverter circuit 23b_22 and a signal RENBL, is supplied to the NAND circuits 23b_5 and 23b_6 through an inverter circuit 23b_24 (path switching circuit).

The above arrangement allows a path for inputting/outputting cell data from being disconnected from the data input/output terminalsI/Oi in the test mode. Data Di from the switching circuits 31C can thus be prevented from conflicting with the cell data in the test mode without bringing the device into a disable state. The data input/output buffer circuit (first buffer circuit) 23'shown in FIG. 6 is connected to the data input/output terminal I/Oi (i = 0 in this case) to/from which cell data is input/output, while the data input/output buffer circuit (second buffer circuit) 23A' shown in FIG. 14 is connected to the other data input/output terminals I/Oi (i = 1 to 14 in this case) from which at least the timing control signals are output. Thus, the normal cell data as well as the timing control signals can be monitored in the test mode.

The switch circuits 31C include a plurality of switch circuits 31C'. FIG. 15 shows an example of arrangement of one of the switch circuits 31C'. Each of the switch circuits 31C' converts an input signal Si into data Di in the test mode (the level of signal RWTEST is high) and outputs it to the data input/output buffer circuits 23A and includes three inverter circuits 31C_₁, 31C_₂ and 31C_₃ and one transfer gate 31C_₄.

The semiconductor memory chip so configured can be set in both the read monitor test mode and write monitor test mode. A plurality of timing control signals, which are generated in the chip in the normal read mode, can simultaneously be monitored in the read monitor test mode. Upon receiving a test signal TEST, the test control circuit 32A performs a test entry operation. When the level of signal AR(1) is low (L), the circuit 32A outputs a high-level signal RTEST to the internal control signal generation circuits 21A and also outputs a high-level signal RWTEST to the internal control signal generation circuit 21A, data input/output buffer circuits 23A, and switch circuits 31C. Thus, an output path of the timing control signals is connected to the data input/output terminals I/Oi. In other words, the switch circuits 31C are connected to the data input/output terminals I/Oi through the data input/output buffer circuits 23A. Then, the device is brought into an active state (the level of signal CEB is low). Therefore, data D(1) to D (12) corresponding to the input signals (timing control signals in the normal read mode) S(1) to S (12) are supplied to the data input/output buffer circuits 23A. Consequently, the data D(1) to D (12) are output from the data input/output terminals I/O (1) to1/0 (12) irrespective of signals OEB and WEB.

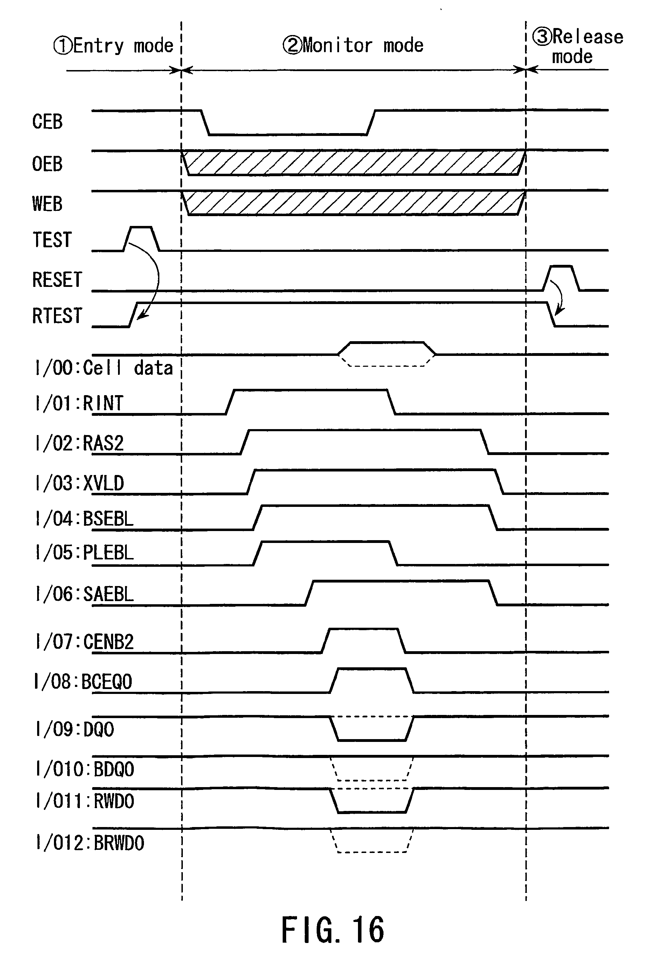

FIG. 16 shows an example of a signal waveform in the read monitor test mode. In the second embodiment, the signals RINT (S(1)), RAS2 (S(2)), XVLD (S(3)), BSEBL (S(4)), PLEBL (S(5)), SAEBL (S(6)), CENB2 (S(7)), and BCEQO (S(8)) and data DQO (S(9)), BDQO (S(10)), RWDO (S(11)), and BRWDO (S(12)) are output from the data input/output terminals I/O(1), I/O(2), I/O(3), I/O(4), I/O(5), I/O(6), I/O(7), I/O(8), I/O(9), I/O(10), I/O(11), and I/O(12), respectively, as timing control signals in the normal read mode.

Similarly, when the level of signal AR(1) is high (H), the test control circuit 32A outputs a high-level signal WTEST to the internal control signal generation circuit 21A in the test entry operation. The circuit 23A also outputs a high-level signal RWTEST to the internal control signal generation circuit 21A, data input/output buffer circuits 23A, and switch circuits 31C. Thus, the switch circuits 31C supply data D(1) to D (12), which correspond to their respective input signals (timing control signals in the normal write mode), to the data input/output buffer circuits 23A. Data D(1) to D (12) are therefore output from the data input/output terminals I/O(1) to I/O(12), respectively.

In the second embodiment, the normal cell data is input/output to/from the data input/output terminal I/O(0). It is thus possible to easily confirm whether the internal operation in the test mode is performed by the timing of the normal operating mode.

Upon receiving a reset signal RESET from a test entry circuit (not shown) in the read monitor test mode or the write monitor test mode, the test control circuit 32A carries out a release operation (the levels of signals RTEST, WTEST and RWTEST are all low). Thus, the device can be operated in the normal operating mode.

As described above, substantially the same advantages as those of the first example can be expected from the second example. More specifically, a plurality of timing control signals to be monitored can simultaneously be output from a plurality of data input/output terminals used for input and output of cell data. It is thus possible to easily and accurately evaluate timing of an internal operation, a delay in signal, etc. using an established tester. The plurality of timing control signals in the normal write mode as well as in the normal read mode can sufficiently be output without conflicting with cell data. Consequently, the internal operation of the semiconductor memory chip, such as an operating margin, can be analyzed with high precision at low cost in a short time without forming any sample chip for evaluation or using any expensive apparatus exclusively for evaluation, and a large amount of data can be acquired.

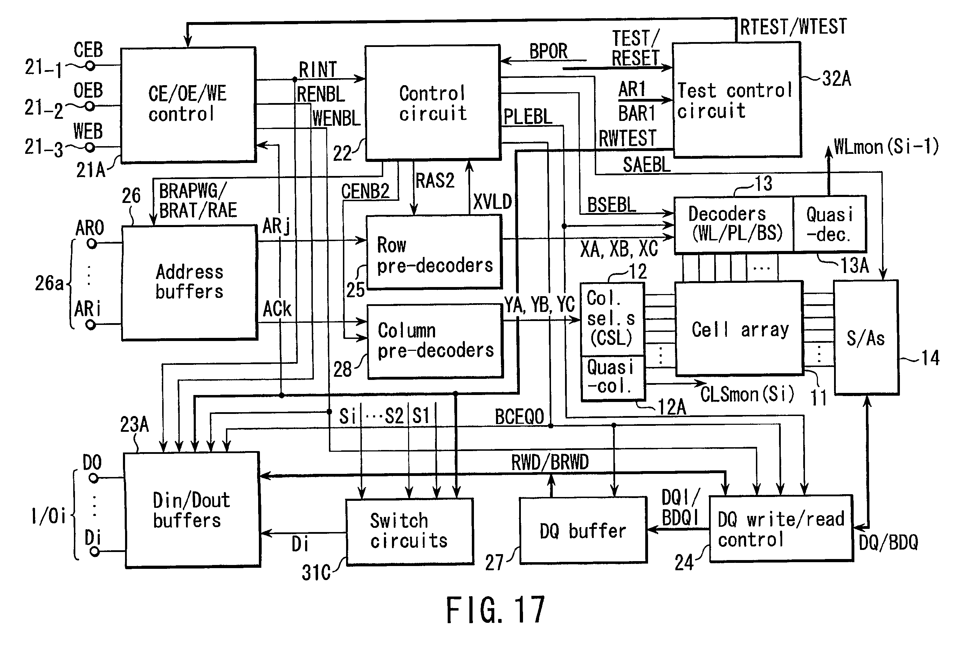

FIG. 17 shows a third example of a configuration of a semiconductor memory device (semiconductor memory chip) instrumental for describing the present invention. The third example allows a word line driving signal and a column select line driving signal to be monitored in the semiconductor memory chip illustrated in FIG. 11. The same components as those of the second example are denoted by the same reference numerals and their detailed descriptions are omitted.

In order to monitor a word line driving signal and a column select line driving signal in the semiconductor memory chip, only one word line or column select line is usually selected from among a plurality of lines (e. g. , 1024 word lines and 512 column select lines). In other words, all the word line driving signals and column select line driving signals cannot be monitored. If a specific word line driving signal is monitored, its capacity will differ from that of another word line. If an address is changed, the timing of signals cannot be evaluated.

In the third example, as shown in FIG. 17, a quasi-row decoder circuit (Quasi-dec.) 13A is provided to monitor a quasi-word line driving signal WLmon and a quasi-column select circuit (Quasi-col.) 12A is provided to monitor a quasi-column select line driving signal CSLmon.

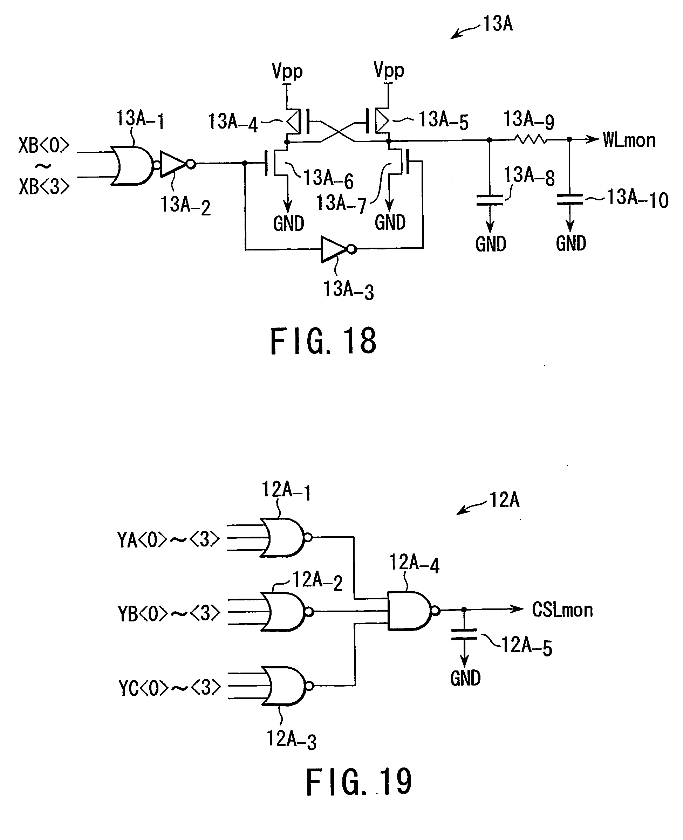

FIG. 18 shows an example of arrangement of the quasi-row decoder circuit 13A. The quasi-row decoder circuit 13A is equivalent to the decoder circuits 13 described above. The circuit 13A generates a quasi-word line driving signal WLmon based on all addresses XB<0> to XB<3> and includes one NOR circuit 13A_₁, two inverter circuits 13A_₂ and 13A_₁, two p-channel MOS transistors 13A_₄ and 13A_₅, two n-channel MOS transistors 13A_₆ and 13A_₇, two capacitors 13A_₈ and 13A_₁₀, and one resistor 13A_₉. The capacitors 13A_₈ and 13A_₁₀ and resistor 13A_₉ are arranged to make the capacity of the circuit 13A correspond to that of a normal word line.

FIG. 19 shows an example of arrangement of the quasi-column select circuit 12A. The quasi-column select circuit 12A is equivalent to the column select circuits 12 described above. The circuit 12A generates a quasi-column select line driving signal CSLmon based on all addresses YA<0> to <3> ,YB<0> to <3>, and YC<0> to <3> and includes three NOR circuits 12A_₁, 12A_₂ and 12A_₃, one NAND circuit 12A_₄, and one capacitor 12A_₅. The capacitor 12A_₅ has parasitic capacitance.

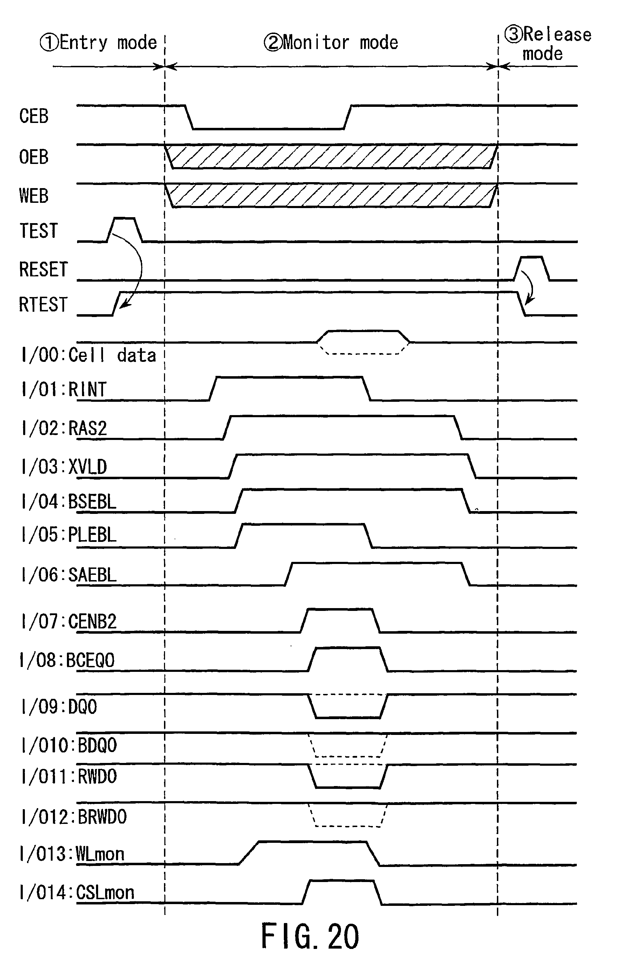

FIG. 20 shows an example of a signal waveform in a read monitor test mode in the semiconductor memory chip according to the third embodiment. In this embodiment, a quasi-word line driving signal WLmon (Si-1) and a quasi-column select line driving signal CSLmon (Si) are output from the data input/output terminals I/O (13) and (14), respectively as timing control signals as well as twelve different timing control signals shown in FIG. 16.

The quasi-word line driving signal WLmon and quasi-column select line driving signal CSLmon can be monitored. Consequently, even when all the word line driving signals and all the column select line driving signals are difficult to monitor, they can be monitored in a quasi-manner.

The above technique is not limited to the above case where the quasi-word line driving signal WLmon and quasi-column select line driving signal CSLmon are monitored. For example, when it is difficult to monitor all of a plurality of signals in different select circuits for selecting a specific one from among the signals, they can easily be monitored by generating a quasi-signal from their equivalent circuit.

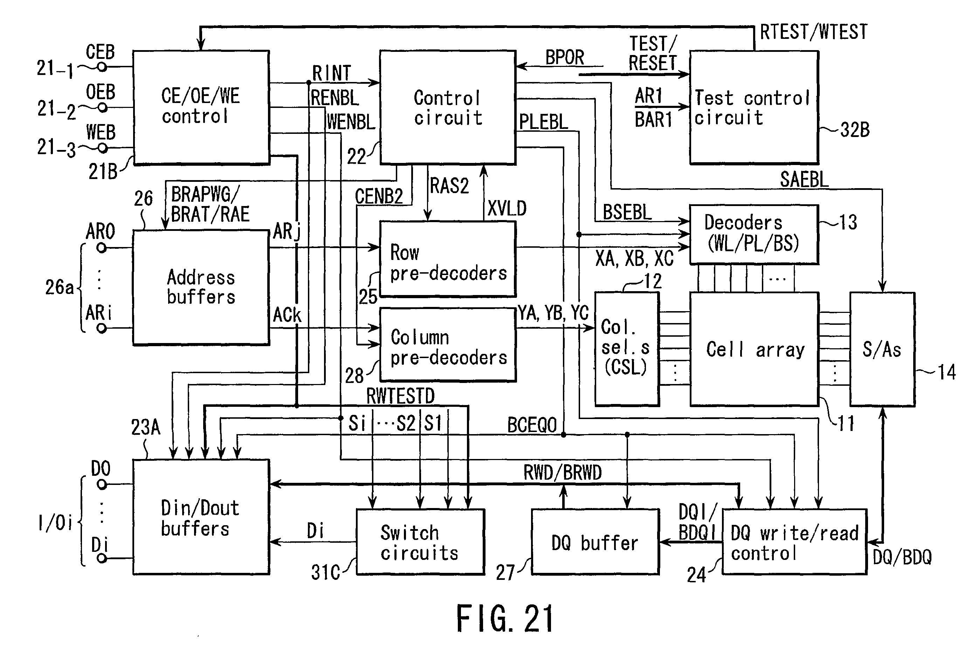

FIG. 21 shows a fourth example of a configuration of a semiconductor memory device (semiconductor memory chip) instrumental for describing the present invention. The fourth example allows a test mode and a normal operating mode to be switched in response to external control signals CEB, OEB and WEB. The same components as those of the second example are denoted by the same reference numerals and their detailed descriptions are omitted.

In the fourth example, an internal control signal generation circuit 21B supplies an output test signal RWTESTD to data input/output buffer circuits 23A and switch circuits 31C, as illustrated in FIG. 21. A test control circuit 32B generates only test signals RTEST and WTEST that are to be output to the internal control signal generation circuit 21B.

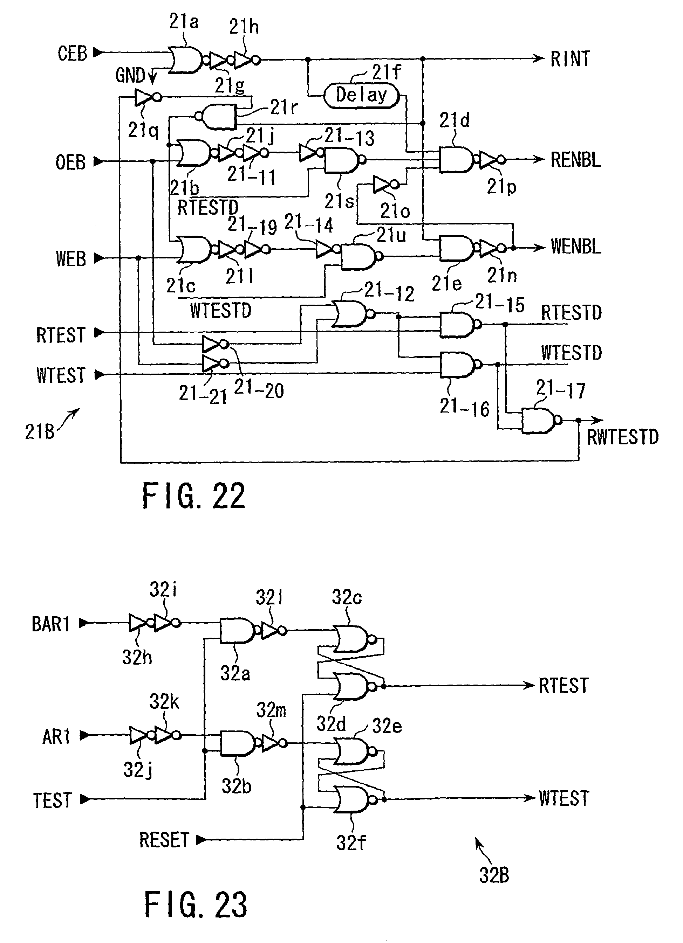

FIG. 22 shows an example of arrangement of the internal control signal generation circuit 21B. The circuit 21B generates signals RWTESTD, RTESTD and WTESTD as well as signals RINT, RENBL and WENBL and allows a test mode and normal read and write modes for reading/writing cell data to be switched in response to signals OEB and WEB.

The signal CEB is supplied to one input terminal of a NOR circuit 21a. The other input terminal of the NOR circuit 21a is grounded (GND). An output of the NOR circuit 21a is produced as the signal RINT through inverter circuits 21g and 21h. The output (signal RINT) of the inverter circuit 21h is supplied to a first input terminal of a NAND circuit 21d via a delay circuit 21f. The output (signal RINT) of the inverter circuit 21h is also supplied to one input terminal of each of NAND circuits21e and 21r. The signal RWTESTD is supplied to the other input terminal of the NAND circuit 21r via an inverter circuit 21q. An output of the NAND circuit 21r is supplied to one input terminal of each of NOR circuits 21b and 21c. The signal OEB is supplied to the other input terminal of the NOR circuit21b. An output of the NOR circuit 21b is supplied to one input terminal of a NAND circuit 21s through inverter circuits 21j, 21_₁₁ and 21_13. The signal RTESTD is supplied to the other input terminal of the NAND circuit 21s. An output of the NAND circuit 21s is supplied to a second input terminal of the NAND circuit 21d. The signal WEB is supplied to the other input terminal of the NOR circuit 21c. An output of the NOR circuit 21c is supplied to one input terminal of a NAND circuit21u via the inverter circuits 211, 21_₁₉ and 21_₁₄. The signal WTESTD is supplied to the other input terminal of the NAND circuit 21u. An output of the NAND circuit 21u is supplied to the other input terminal of the NAND circuit 21e. An output of the NAND circuit 21e is produced as a signal WENBL through an inverter circuit 21n and supplied to a third input terminal of the NAND circuit 21d through an inverter circuit 210. An output of the NAND circuit 21d is produced as the signal RENBL through an inverter circuit 21p.

The signal OEB is supplied to one input terminal of a NOR circuit 21_₁₂ via an inverter circuit 21_₂₀. The signal WEB is supplied to the other input terminal of the NOR circuit 21_₁₂ via an inverter circuit 21_₂₁. An output of the NOR circuit 21_₁₂ is supplied to one input terminal of each of NAND circuits 21_₁₅ and 21_₁₆. The signal RTEST is supplied to the other input terminal of the NAND circuit 21_₁₅. The signal WTEST is supplied to the other input terminal of the NAND circuit 21_₁₆. An output of the NAND circuit 21_₁₅ is produced as the signal RTESTD and supplied to one input terminal of a NAND circuit 21_₁₇. An output of the NAND circuit 21_₁₆ is produced as the signal WTESTD and supplied to the other input terminal of the NAND circuit 21_₁₇. An output of the NAND circuit 21_₁₇ is produced as a signal RWTESTD.

In the internal control signal generation circuit 21B, the levels of signals RTEST and WTEST are all low in the normal read mode for reading cell data and the normal write mode for writing cell data. The levels of signals RTESTD and WTESTD are high, and the level of signal RWTESTD is low. The signals RINT, RENBL and WENBL depend upon signals CEB, OEB and WEB. In a standby state, the level of signal CEB is high and the levels of signals RINT, RENBL and WENBL are low. In the read mode, the levels of signals CEB and OEB are low, the level of signal WEB is high, and the levels of signals RINT and RENBL are high, and the level of signal WENBL is low. In the write mode, the levels of signals CEB and WEB are low, the level of signal OEB is high, the levels of signals RINT and WENBL are high, and the level of signal RENBL is low. In the normal mode, the level of signal RWTESTD is low, and an output path of the timing control signals is not connected to the data input/output terminal I/Oi.

In the test mode, the level of signal CEB is low and the levels of signals OEB and WEB are high. In the read monitor test mode, the level of signal RTEST is high and that of signal RTESTD is low. The level of signal CEB is low, but that of RINT is high. As in the second embodiment, the level of signal RENBL is high and the internal operation is brought into a read operating state. On the other hand, in the write monitor test mode, the level of signal WTEST is high and that of signal WENBL is high, and the internal operation is brought into a write operating state.

In both the test modes, the level of signal RWTESTD becomes high. Thus, an internal circuit (output path of cell data) separates from the internal control signal generation circuit 21B. In other words, the switch circuits 31C and data input/output terminals I/Oi are connected to each other in order to output data (timing control signal) Di from the switch circuits 31C.

If signal OEB or WEB is set at a low level at the same time when signal CEB is set at a low level, the levels of signals RTESTD and WTESTD become high.

Consequently, signals RENBL and WENBL vary with external control signals CEB, OEB and WEB. If the level of signal OEB is low, that of signal RENBL is high. If the level of signal WEB is low, that of signal WENBL is high. The level of signal RWTESTD is low. The states of the data input/output buffer circuits 23A and switch circuits 31C are equal to those in the normal operation mode. Therefore, the device can read and write cell data. Even though the signals RTEST and WTEST are set at a high level in the test modes described above, they can be switched to the normal operation mode by setting the levels of signals OEB and WEB low.

FIG. 23 shows an example of arrangement of the test control circuit 32B. As in the test control circuit 32A shown in FIG. 12, an output of the NOR circuit 32d is produced as a signal RTEST and that of the NOR circuit 32f is produced as a signal WTEST. However, the circuit 32B includes neither the NOR circuit 32g nor inverter circuit 32n which generates the signal RWTEST.

The switch circuits 31C corresponds to the switch circuit 31C' shown in FIG. 15 to which the internal control signal generation circuit 21B supplies a signal RWTESTD in place of the signal RWTEST.

In the fourth example described above, when the levels of signals OEB and WEB are high and the level of signal CEB is low, the device is set in the test mode. In this case, the data input/output terminals I/Oi output timing control signals. If the level of signal CEB is low but that of signal OEB is low, the device is set in the normal read mode. In this case, not the timing control signals but normal cell data is output from the data input/output terminal I/Oi. When the level of signal WEB is low, the device is set in the normal write mode. In this case, data Di is written to the memory cell from the data input/output terminals I/Oi.

According to the fourth example, the normal operating mode and the test modes for monitoring an internal operation can easily be switched by a combination of external control signals. For this reason, the device of the present invention efficiently operates particularly when the internal operation is monitored while comparing two states of the normal operating mode and test modes and while rewriting data.

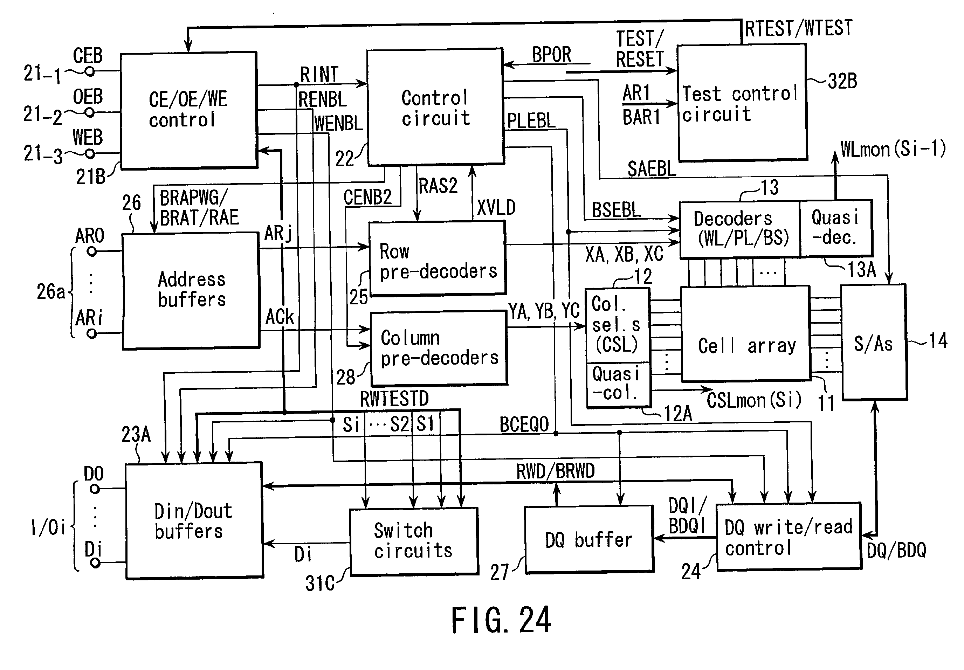

FIG. 24 shows a fifth example of a configuration of a semiconductor memory device (semiconductor memory chip) instrumental in describing the present invention. In this embodiment, the test modes and normal operating mode can be switched in response to an external control signal (fourth example) and the word line driving signal and column select line driving signal can be monitored (third example). The same components as those of the foregoing third and fourth examples are denoted by the same reference numerals and their detailed descriptions are omitted.

The fifth example corresponds to the semiconductor memory chip shown in FIG. 21 to which the quasi-column select circuit 12A (see FIG. 19) and the quasi-row decoder circuit 13A (see FIG. 18) are added.

The configuration of the fifth example allows a semiconductor memory chip having both functions of the third and fourth examples to be achieved. More specifically, not only the test modes and normal operating mode can be switched in response to an external control signal but also the quasi-word line driving signal WLmon and quasi-column select line driving signal CSLmon can be monitored.

### (Embodiment of the Present Invention)

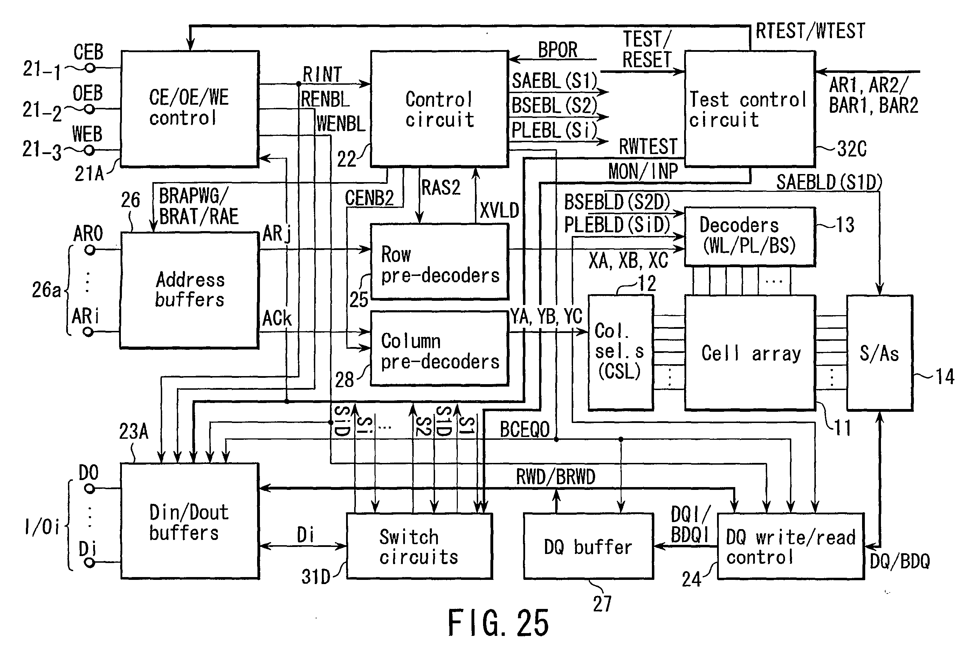

FIG.25 shows an example of a configuration of a semiconductor memory device (semiconductor memory chip) according to an embodiment of the present invention. The semiconductor memory device has an external control mode for allowing timing control signals to receive from outside as well as a monitor test mode for outputting timing control signals from data input/output terminals I/Oi. The same components as those of the second example are denoted by the same reference numerals and their detailed descriptions are omitted.

According to the embodiment, as illustrated in FIG. 25, the device is set in the test mode or external control mode in response to signals MON and INP supplied to switch circuits 31D from a test control circuit 32C. When the level of signal MON is high, the device is set in the test mode. When the level of signal INP is high, the device is set in the external control mode. The signals MON and INP are controlled by a combination of signals AR(1), BAR(1), AR(2) and BAR(2) supplied from the address input terminals 26a of address buffer circuits 26.

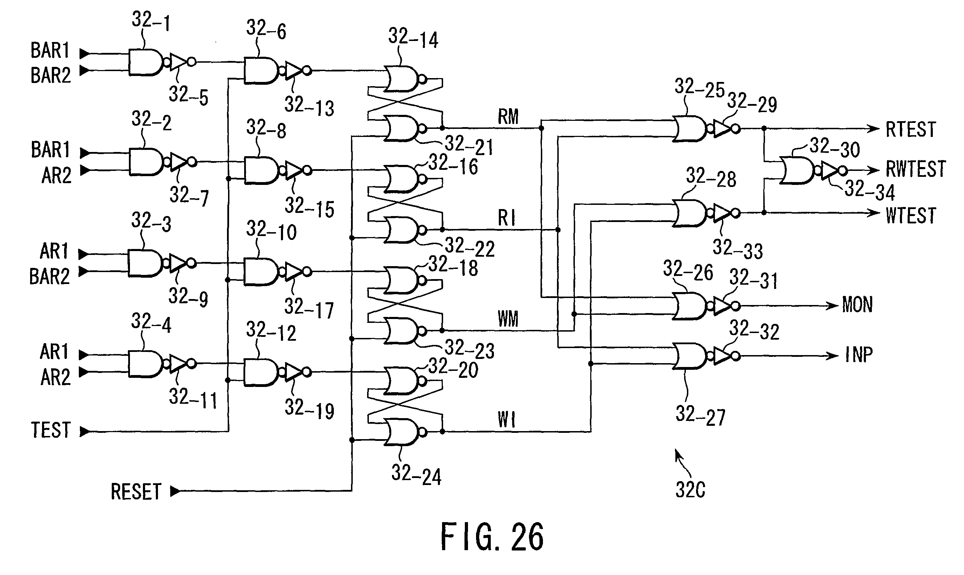

FIG. 26 shows an example of arrangement of the test control circuit 32C. The signal BAR(1) is supplied to one input terminal of a NAND circuit32_₁ and one input terminal of a NAND circuit 32_₂. The signal BAR(2) is supplied to the other input terminal of the NAND circuit 32_₁ and one input terminal of a NAND circuit 32_₃. The signal BAR(2) is supplied to the other input terminal of the NAND circuit 32_₂ and one input terminal of a NAND circuit 32_₄. The signal AR(1) is supplied to the other input terminal of the NAND circuit 32_₃ and the other input terminal of the NAND circuit 32_₄. An output of the NAND circuit NAND circuit 32_₂ is supplied to one input terminal of a NAND circuit 32_₈ through an inverter circuit 32_₇. An output of the NAND circuit 32_₃ is supplied to one input terminal of a NAND circuit 32_₁₀ through an inverter circuit 32_₉. An output of the NAND circuit 32_₄ is supplied to one input terminal of a NAND circuit 32_₁₂ through an inverter circuit 32_₁₁. A signal TEST is supplied to the other input terminals of the NAND circuits 32_₆, 32_₈, 32_₁₀, and 32_₁₂. An output of the NAND circuit 32_₆ is supplied to one input terminal of a NOR circuit 32_₁₄ through an inverter circuit 32_₁₃. An output of the NAND circuit 32_₈ is supplied to one input terminal of a NOR circuit 32_₁₆ via an inverter circuit 32_₁₅. An output of the NAND circuit 32_₁₀ is supplied to one input terminal of a NOR circuit 32_₁₈ through an inverter circuit 32_₁₇. An output of the NAND circuit 32_₁₂ is supplied to one input terminal of a NOR circuit 32_₂₀ through an inverter circuit 32_₁₉.

An output of the NOR circuit 32_₁₄ is supplied to one input terminal of a NOR circuit 32_₂₁. An output of the NOR circuit 32_₁₆ is supplied to one input terminal of a NOR circuit 32_₂₂. An output of the NOR circuit 32_₁₈ is supplied to one input terminal of a NOR circuit 32_₂₃. An output of the NOR circuit 32_₂₀ is supplied to one input terminal of a NOR circuit 32_₂₄. A signal RESET is supplied to the other input terminals of the NOR circuits 32_₂₁, 32_₂₂, 32_₂₃ and 32_₂₄. An output (RM) of the NOR circuit 32_₂₁ is supplied to the other input terminal of the NOR circuit 32_₁₄ and one input terminal of each of the NOR circuits 32_₂₅ and 32_₂₆. An output (RI) of the NOR circuit 32_₂₂ is supplied to the other input terminal of the NOR circuit 32_₁₆ and the other input terminals of the NOR circuits 32_₂₅ and 32_₂₇. An output (WM) of the NOR circuit 32_₂₃ is supplied to the other input terminal of the NOR circuit 32_₁₈ and to the other input terminal of the NOR circuit 32_₂₆ and one input terminal of the NOR circuit 32_₂₈. An output (WI) of the NOR circuit 32_₂₄ is supplied to the other input terminal of the NOR circuit 32_₂₀ and the other input terminals of the NOR circuits 32_₂₇ and 32_₂₈.

An output of the NOR circuit 32_₂₅ is produced as a signal RTEST through an inverter circuit 32_₂₉ and supplied to one input terminal of a NOR circuit 32_₃₀ An output of the NOR circuit 32_₂₆ is produced as a signal MON through an inverter circuit 32_₃₁ (mode select circuit). An output of the NOR circuit 32_₂₇ is produced as a signal INP through an inverter circuit 32_₃₂ (mode select circuit). An output of the NOR circuit 32_₂₈ is produced as a signal WTEST through an inverter circuit 32_₃₃ and supplied to the other input terminal of the NOR circuit 32_₃₀. An output of the NOR circuit 32_₃₀ is produced as a signal RWTEST through an inverter circuit 32_₃₄.

In the test control circuit 32C so arranged, when the levels of signals AR(1) and AR(2) are low (L), the level of signal MON becomes high (H) and so does that of signal RTEST. In this case, the circuit is brought into a read monitor test mode for monitoring timing control signals in the normal read mode. When the level of signal AR(1) is low (L) and that of signal AR(2) is high (H), the level of signal INP becomes high and so does that of signal RTEST. In this case, the circuit is brought into a read and external control mode for allowing timing control signals to receive in the normal read mode. When the level of signal AR(1) is high (H) and that of signal AR(2) is low (L), the level of signal MON becomes high (H) and so does that of signal WTEST. In this case, the circuit is brought into a write monitor test mode for monitoring timing control signals in the normal write mode. When the levels of signals AR(1) and AR(2) are high (H), the level of signal INP becomes high and so does that of signal WTEST. In this case, the circuit is brought into a write and external control mode for allowing timing control signals to receive in the normal write mode.

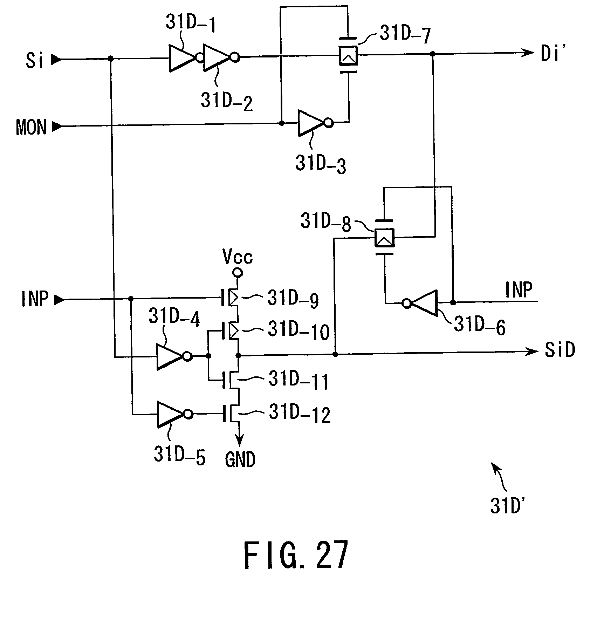

The switch circuits 31D include a plurality of switch circuits 31D'. FIG. 27 shows an example of one of the switch circuits 31D'. Each of the switch circuits 31D' includes six inverter circuits 31D_₁, 31D_₂,..., and 31D_₆, two transfer gates 31D_₇ and 31D_₈, two p-channel MOS transistors 31D_₉ and 31D_₁₀, and two n-channel MOS transistors 31D_₁₁ and 31D_₁₂.

When the level of signal INP is high (H), the switch circuit 31D' receives a plurality of timing control signals as data Di from the data input/output terminals I/Oi through the data input/output buffer circuits 23A. Then, the circuit 31D' supplies the data Di to the respective components as data SiD. On the other hand, when the level of signal MON is high, the circuit 31D' receives a plurality of timing control signals as input signals Si. Then, the circuit 31D' converts the input signal Si into data Di and outputs it to the data input/output buffer circuits 23A from the data input/output terminals I/Oi.

Of the timing control signals, for example, signals SAEBL(S1), BSEBL(S2),..., and PLEBL(Si) are supplied through the switch circuits 31D as signals SAEBLD(S1D), BSEBLD(S2D),..., and PLEBLD(SiD), respectively.

The timing control signals can thus be supplied from outside. Consequently, the timing of an internal operation, a delay in signal, etc. can be evaluated more easily.

### (Another Embodiment of the Invention)

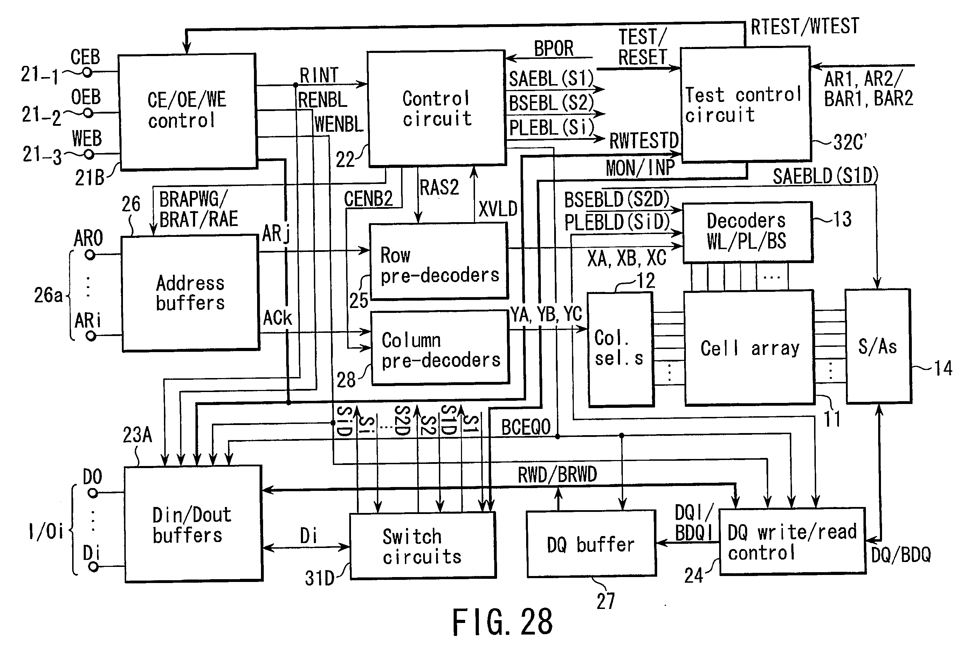

FIG. 28 shows an example of a configuration of a semiconductor memory device (semiconductor memory chip) according to another embodiment of the present invention. In the embodiment, as shown in Fig. 28, an external control mode for allowing timing control signals to receive from outside can be set (previous embodiment of the invention) and a test mode and a normal operating mode can be switched to each other in response to external control signals (fourth example). The same components as those of the fourth example and previous embodiment of the present invention are denoted by the same reference numerals and their detailed descriptions are omitted.

The embodiment, as shown in Fig. 28, corresponds to the semiconductor memory chip shown in FIG. 25 in which the internal control signal generation circuit 21B (see FIG. 22) supplies an output test signal RWTESTD to the data input/output buffer circuits 23A and test control circuit 32C'.

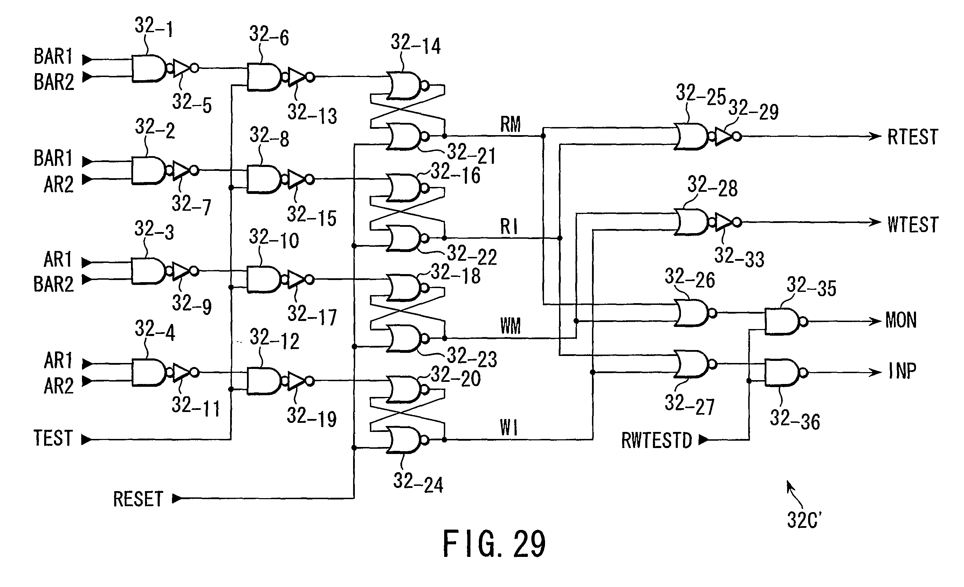

FIG. 29 shows an example of arrangement of the test control circuit 32C'. In this circuit, an output of a NOR circuit 32_₂₆ is supplied to one input terminal of a NAND circuit 32_₃₅. An output of a NOR circuit 32_₂₇ is supplied to one input terminal of a NAND circuit 32_₃₆. An output test signal RWTESTD is supplied to the other input terminals of the NAND circuits 32_₃₅ and 32_₃₆ from the internal control signal generation circuit 21B. Then, an output of the NAND circuit 32_₃₅ is produced as a signal MON and that of the NAND circuit 32_₃₆ is produced as a signal INP. However, the test control circuit 32C' includes neither a NOR circuit 32_₃₀ for generating a signal RWTEST nor an inverter circuit 32_₃₄.

With the above circuit arrangement, a semiconductor memory chip having both the function according to the fourth example and the function (external control mode) according to the previous embodiment of the invention can be achieved. More specifically, not only the test mode and normal operating mode can be switched to each other in response to external control signals, but also timing control signals can be supplied from outside in a mode different from the test mode for outputting the timing control signals from the data input/output terminals I/Oi.

In the respective embodiments described above, upon receiving a test signal TEST, which is a pulse signal from a test entry circuit, the semiconductor memory chip is set in the test mode. As another method, for example, a high-voltage signal or a command can be input to set the chip in the test mode.

## Claims

1. A semiconductor memory device comprising:
a memory cell array (11);
a plurality of input/output terminals (I/Oi) to input cell data (Di) written to the memory cell array (11) and output cell data (Di) read from the memory cell array (11);
data input/output buffer circuits (23A) connected to said plurality of input/output terminals (I/Oi); and
a test control setting circuit (32C) **characterized in that**
the test control circuit (32C) sets either a test mode to monitor a plurality of timing control signals (Si) which control input/output operation timing of the cell data or an external control mode allowing input of desired timing control signals (Si) from outside via the plurality of input/output terminals (I/Oi) and the data input/output buffer circuits (23A) for test purposes into the semiconductor memory device, in accordance with a combination of external address signals (AR(1), AR(2)); and
switch circuits (31D), which are connected to the plurality of input/output terminals (I/Oi) through the data input/output buffer circuits (23A), which output the plurality of timing control signals (Si) from the plurality of input/output terminals (I/Oi) in the test mode and receive the desired timing control signals (Si) in the external control mode.

2. The semiconductor memory device according to claim 1, wherein the test control circuit (32C) is adapted to supply a first control signal (MON) and a second control signal (INP) to the switch circuits (31D) and wherein when the level of the first control signal (MON) is high, the memory device is set in the test mode and when the level of the second control signal (INP) is high, the memory device is set in the external control mode.

3. The semiconductor memory device according to claim 2, wherein the test control circuit (32C) is adapted to be brought into a read monitor test mode for monitoring timing control signals in a normal read mode.

4. The semiconductor memory device according to claim 3, wherein when the level of a first and a second external address signal (AR(1), AR(2)) is low, the level of the first control signal (MON) and that of a third control signal (RTEST) become high (H) such that the test control circuit (32C) is brought into said read monitor test mode.

5. The semiconductor memory device according to claim 1 or 2, wherein the test control circuit (32C) is adapted to be brought into a read and external control mode for allowing desired timing control signals to be received in a normal read mode.

6. The semiconductor memory device according to claim 2, wherein the test control circuit (32C) is adapted to be brought into a read and external control mode for allowing desired timing control signals to be received in a normal read mode and wherein when the level of the first external address signal (AR(1)) is low and the level of the second external signal AR(2) is high, the level of the second control signal (INP) and of a third control signal (RTEST) becomes high (H) such that the test control circuit (32C) is brought into said read and external control mode.

7. The semiconductor memory device according to claim 1, wherein the test control circuit (32C) is adapted to be brought into a write monitor test mode for monitoring timing control signals in a normal write mode.

8. The semiconductor memory device according to claim 7, wherein when the level of the first external address signal (AR(1)) is high and the level of the second external address signal AR(2) is low, the level of first control signal (MON) and of a fourth control signal (WTEST) becomes high (H) such that the test control circuit (32C) is brought into said normal write mode.

9. The semiconductor memory device according to claim 1 or 2, wherein the test control circuit (32C) is adapted to be brought into a write and external control mode for allowing timing control signals to be received in a normal write mode.

10. The semiconductor memory device according to claim 2, wherein the test control circuit (32C) is adapted to be brought into a write and external control mode for allowing timing control signals to be received in a normal write mode and wherein when the level of the first external address signal (AR(1)) and of the second external address signal AR(2) is high, the level of the second control signal (INP) and of a fourth control signal (WTEST) becomes high (H) such that the test control circuit (32C) is brought into said write and external control mode.

## Patentansprüche

1. Eine Halbleiterspeichereinrichtung, umfassend:'
ein Speicherzellenfeld (11);
eine Vielzahl von Eingangs-/Ausgangsanschlüssen (I/Oi), um Zellendaten (Di) einzugeben, die zu dem Speicherzellenfeld (11) geschrieben sind, und Zellendaten (Di) auszugeben, die aus dem Speicherzellenfeld (11) gelesen werden;
Dateneingabe-/Ausgabepufferschaltungen (23A), die mit der Vielzahl von Eingangs-/Ausgangsanschlüssen (I/Oi) verbunden sind; und
eine Teststeuereinstellungsschaltung (32C), **gekennzeichnet dadurch, dass**
die Teststeuerschaltung (32C) entweder einen Testmodus, um eine Vielzahl von Zeitsteuerungssteuersignalen (Si) zu überwachen, die Eingabe-/Ausgabeoperationszeitsteuerung der Zellendaten steuern, oder einen externen Steuermodus setzt, der Eingabe gewünschter Zeitsteuerungssteuersignale (Si) von außerhalb über die Vielzahl von Eingangs-/Ausgangsanschlüssen (I/Oi) und die Dateneingabe-/Ausgabepufferschaltungen (23A) für Testzwecke in die Halbleiterspeichereinrichtung erlaubt, in Übereinstimmung mit einer Kombination von externen Adresssignalen (AR(1), AR(2)); und
Schaltkreise (31D), die mit der Vielzahl von Eingangs-/Ausgangsanschlüssen (I/Oi) durch die Dateneingabe-/Ausgabepufferschaltungen (23A) verbunden sind, die die Vielzahl von Zeitsteuerungssteuersignalen (Si) von der Vielzahl von Eingangs-/Ausgangsanschlüssen (I/Oi) in dem Testmodus ausgeben und die gewünschten Zeitsteuerungssteuersignale (Si) in dem externen Steuermodus empfangen.

2. Die Halbleiterspeichereinrichtung nach Anspruch 1, wobei die Teststeuerschaltung (32C) angepasst ist, ein erstes Steuersignal (MON) und ein zweites Steuersignal (INP) den Schaltkreisen (31D) zuzuführen, und wobei wenn der Pegel des ersten Steuersignals (MON) hoch ist, die Speichereinrichtung in den Testmodus gesetzt wird, und wenn der Pegel des zweiten Steuersignals (INP) hoch ist, die Speichereinrichtung in den externen Steuermodus gesetzt wird.

3. Die Halbleiterspeichereinrichtung nach Anspruch 2, wobei die Teststeuerschaltung (32C) angepasst ist, in einen Leseüberwachungstestmodus zum Überwachen von Zeitsteuerungssteuersignalen in einem normalen Lesemodus gebracht zu werden.

4. Die Halbleiterspeichereinrichtung nach Anspruch 3, wobei wenn der Pegel eines ersten und eines zweiten externen Adresssignals (AR(1), AR(2)) tief ist, der Pegel des ersten Steuersignals (MON) und der eines dritten Steuersignals (RTEST) hoch (H) werden, derart, dass die Teststeuerschaltung (32C) in den Leseüberwachungstestmodus gebracht wird.

5. Die Halbleiterspeichereinrichtung nach Anspruch 1 oder 2, wobei die Teststeuerschaltung (32C) angepasst ist, in einen Lese- und externen Steuermodus gebracht zu werden um zu erlauben, dass gewünschte Zeitsteuerungssteuersignale in einem normalen Lesemodus empfangen werden.

6. Die Halbleiterspeichereinrichtung nach Anspruch 2, wobei die Teststeuerschaltung (32C) angepasst ist, in einen Lese- und externen Steuermodus gebracht zu werden um zu erlauben, dass gewünschte Zeitsteuerungssteuersignale in einem normalen Lesemodus empfangen werden und wobei wenn der Pegel des ersten externen Adresssignals (AR(1)) tief ist und der Pegel des zweiten externen Signals (AR(2)) hoch ist, der Pegel des zweiten Steuersignals (INP) und eines dritten Steuersignals (RTEST) hoch (H) wird, derart, dass die Teststeuerschaltung (32C) in den Lese- und externen Steuermodus gebracht wird.

7. Die Halbleiterspeichereinrichtung nach Anspruch 1, wobei die Teststeuerschaltung (32C) angepasst ist, in einen Schreibüberwachungstestmodus zum Überwachen von Zeitsteuerungssteuersignalen in einem normalen Schreibmodus gebracht zu werden.

8. Die Halbleiterspeichereinrichtung nach Anspruch 7, wobei wenn der Pegel des ersten externen Adresssignals (AR(1)) hoch ist und der Pegel des zweiten externen Adresssignals AR(2) tief ist, der Pegel eines ersten Steuersignals (MON) und eines vierten Steuersignals (WTEST) hoch (H) wird, derart, dass die Teststeuerschaltung (32C) in den normalen Schreibmodus gebracht wird.

9. Die Halbleiterspeichereinrichtung nach Anspruch 1 oder 2, wobei die Teststeuerschaltung (32C) angepasst ist, in einen Schreib- und externen Steuermodus gebracht zu werden um zu erlauben, dass Zeitsteuerungssteuersignale in einem normalen Schreibmodus empfangen werden.

10. Die Halbleiterspeichereinrichtung nach Anspruch 2, wobei die Teststeuerschaltung (32°C) angepasst ist, in einen Schreib- und externen Steuermodus gebracht zu werden um zu erlauben, dass Zeitsteuerungssteuersignale in einem normalen Schreibmodus empfangen werden und wobei wenn der Pegel des ersten externen Adresssignals (AR(1)) und des zweiten externen Adresssignals AR(2) hoch ist, der Pegel des zweiten Steuersignals (INP) und eines vierten Steuersignals (WTEST) hoch (H) wird, derart, dass die Teststeuerschaltung (32C) in den Schreib- und externen Steuermodus gebracht wird.

## Revendications

1. Dispositif de mémoire à semi-conducteurs comprenant :
une matrice de cellules de mémoire (11) ;
une pluralité de bornes d'entrée/sortie (I/Oi) pour entrer des données de cellules (Di) écrites dans la matrice de cellules de mémoire (11) et pour délivrer en sortie des données de cellules (Di) lues à partir de la matrice de cellules de mémoire (11) ;
des circuits tampons d'entrée/sortie de données (23A) connectés à ladite pluralité de bornes d'entrée/sortie (I/Oi) ; et
un circuit de définition de commande de test (32C),
**caractérisé en ce que** :
le circuit de commande de test (32C) définit, soit un mode de test pour contrôler une pluralité de signaux de commande de temporisation (Si) qui commandent une temporisation d'une opération d'entrée/sortie des données de cellules, soit un mode de commande externe qui autorise une entrée de signaux de commande de temporisation (Si) depuis l'extérieur par le biais de la pluralité de bornes d'entrée/sortie (I/Oi) et des circuits tampons d'entrée/sortie de données (23A) à des fins de test, dans le dispositif de mémoire à semi-conducteurs, en accord avec une combinaison de signaux d'adresses externes (AR(1), AR(2)) ; et
des circuits de commutation (31D) qui sont connectés à la pluralité de bornes d'entrée/sortie (I/Oi) par le biais des circuits tampons d'entrée/sortie de données (23A), qui délivrent en sortie la pluralité de signaux de commande de temporisation (Si) à partir de la pluralité de bornes d'entrée/sortie (I/Oi) dans le mode de test, et qui reçoivent les signaux de commande de temporisation (Si) souhaités dans le mode de commande externe.

2. Dispositif de mémoire à semi-conducteurs selon la revendication 1, dans lequel le circuit de commande de test (32C) est adapté pour envoyer un premier signal de commande (MON) et un deuxième signal de commande (INP) vers les circuits de commutation (31D) et dans lequel, quand le niveau du premier signal de commande (MON) est élevé, le dispositif de mémoire est défini dans le mode de test et, quand le niveau du deuxième signal de commande (INP) est élevé, le dispositif de mémoire est défini dans le mode de commande externe.

3. Dispositif de mémoire à semi-conducteurs selon la revendication 2, dans lequel le circuit de commande de test (32C) est adapté pour être amené dans un mode de test de contrôle en lecture pour contrôler des signaux de commande de temporisation dans un mode de lecture normal.

4. Dispositif de mémoire à semi-conducteurs selon la revendication 3' dans lequel, quand le niveau d'un premier et d'un deuxième signaux d'adresses externes (AR(1), AR(2)) est faible, le niveau du premier signal de commande (MON) et le niveau d'un troisième signal de commande (RTEST) deviennent élevés (H), de sorte que le circuit de commande de test (32C) est amené dans ledit mode de test de contrôle en lecture.

5. Dispositif de mémoire à semi-conducteurs selon la revendication 1 ou 2, dans lequel le circuit de commande de test (32C) est adapté pour être amené dans un mode de lecture et de commande externe de façon à permettre à des signaux de commande de temporisation souhaités d'être reçus dans un mode de lecture normal.

6. Dispositif de mémoire à semi-conducteurs selon la revendication 2, dans lequel le circuit de commande de test (32C) est adapté pour être amené dans un mode de lecture et de commande externe de façon à permettre à des signaux de commande de temporisation souhaités d'être reçus dans un mode de lecture normal, et dans lequel, quand le niveau du premier signal d'adresse externe (AR(1)) est faible et que le niveau du deuxième signal d'adresse externe AR(2) est élevé, le niveau du deuxième signal de commande (INP) et le niveau d'un troisième signal de commande (RTEST) deviennent élevés (H), de sorte que le circuit de commande de test (32C) est amené dans ledit mode de lecture et de commande externe.

7. Dispositif de mémoire à semi-conducteurs selon la revendication 1, dans lequel le circuit de commande de test (32C) est adapté pour être amené dans un mode de test de contrôle en écriture pour contrôler des signaux de commande de temporisation dans un mode d'écriture normal.

8. Dispositif de mémoire à semi-conducteurs selon la revendication 7 dans lequel, quand le niveau du premier signal d'adresse externe (AR(1)) est élevé et que le niveau du deuxième signal d'adresse externe AR(2) est faible, le niveau d'un premier signal de commande (MON) et le niveau d'un quatrième signal de commande (WTEST) deviennent élevés (H), de sorte que le circuit de commande de test (32C) est amené dans ledit mode d'écriture normal.

9. Dispositif de mémoire à semi-conducteurs selon la revendication 1 ou 2, dans lequel le circuit de commande de test (32C) est adapté pour être amené dans un mode d'écriture et de commande externe de façon à permettre à des signaux de commande de temporisation d'être reçus dans un mode d'écriture normal.

10. Dispositif de mémoire à semi-conducteurs selon la revendication 2, dans lequel le circuit de commande de test (32C) est adapté pour être amené dans un mode d'écriture et de commande externe de façon à permettre à des signaux de commande de temporisation d'être reçus dans un mode d'écriture normal, et dans lequel, quand le niveau du premier signal d'adresse externe (AR(1)) et le niveau du deuxième signal d'adresse externe AR(2) sont élevés, le niveau du deuxième signal de commande (INP) et le niveau d'un quatrième signal de commande (WTEST) deviennent élevés (H), de sorte que le circuit de commande de test (32C) est amené dans ledit mode d'écriture et de commande externe.
